# EUROPEAN PATENT APPLICATION

(11) **EP 2 903 080 A1**
(43) Date of publication of application: **05.08.2015**
(21) Application number: 13843009.5
(22) Date of filing: 10.09.2013
(51) Int. Cl.: H01M 14/00, C09B 57/10, C09B 67/44, H01L 31/04

(54) **PHOTOELECTRIC CONVERSION ELEMENT AND DYE-SENSITIZED SOLAR CELL**

(30) Priority: 28.09.2012 JP 2012218750; 29.07.2013 JP 2013156799
(71) Applicant: FUJI-FILM Corporation, Minato-ku Tokyo 106-8620 (JP)
(72) Inventor: WATANABE Kohsuke, Ashigarakami-gun Kanagawa 258-8577 (JP); KOBAYASHI Katsumi, Ashigarakami-gun Kanagawa 258-8577 (JP)
(74) Representative: Hoffmann Eitle
(86) International application number: PCT/JP2013/074294
(87) International publication number: WO 2014/050527

(57) **Abstract**

A photoelectric conversion element of the present invention includes a conductive substrate, a photosensitive layer containing an electrolyte, a charge transfer layer containing an electrolyte, and a counter electrode. The photosensitive layer contains semiconductor particles supporting a metal complex dye represented by the following Formula (I). A dye-sensitized solar cell of the present invention includes the photoelectric conversion element.

M(LD)(LA)·(CI) Formula (I)

In the formula, M represents a metal ion; each of LD and LA represents a specific heterocyclic tridentate ligand; and CI represents a counter ion necessary for neutralizing a charge.

## Description

### BACKGROUND OF THE INVENTION

### 1. Field of the Invention

The present invention relates to a photoelectric conversion element and a dye-sensitized solar cell.

### 2. Description of the Related Art

Photoelectric conversion elements are used in various photosensors, copy machines, solar cells, and the like. The photoelectric conversion elements have been put to practical use in the form of photoelectric conversion elements adopting various modes, such as photoelectric conversion element using metals, photoelectric conversion elements using semiconductors, photoelectric conversion elements using organic pigments or dyes, or photoelectric conversion elements as a combination of these. Particularly, because solar cells using inexhaustible solar energy do not require fuels and use wasteless clean energy, full-scale commercialization of the solar cells is highly anticipated. Among the solar cells, silicon-based solar cells have been researched and developed for a long period of time, and are becoming increasingly popular by the political support of each country. However, because silicon is an inorganic material, the improvement of throughput, cost, and the like thereof is inevitably limited.

For this reason, dye-sensitized solar cells are being strenuously researched. Particularly, the research was fueled by the results of research conducted by Graetzel et al. of EPFL of Switzerland. By adopting a structure in which a dye composed of a ruthenium complex is fixed to the surface of a thin film made of porous titanium oxide, Graetzel et al. realized a photoelectric conversion efficiency equivalent to that of amorphous silicon. As a result, the dye-sensitized solar cells that can be manufactured without using an expensive vacuum apparatus instantly drew attention of researchers all over the world.

Up to now, as metal complex dyes used in photoelectric conversion elements, dyes that are generally called N3, N719, Z907, and J2 have been developed. However, in many cases, the dye-sensitized solar cells in the related art generally have a low photoelectric conversion efficiency and poor durability.

In the related art, as a ligand of the metal complex dyes, a combination of bidentate ligands or a combination of a bidentate ligand and a tridentate ligand has been actively examined. However, in order to improve durability, further examination is required.

Meanwhile, in recent years, metal complex dyes having two tridentate ligands have been researched (for example, see US2012/0073660A and JP2009-67976A), and there have been some achievements. However, in current circumstances, it is still difficult to improve durability.

Furthermore, as an energy source alternative to nuclear power generation, solar cells are increasingly getting attention and being anticipated, and performance of the dye-sensitized solar cells is also required to be improved.

### SUMMARY OF THE INVENTION

As the years pass by, the performance level required for the dye-sensitized solar cells is steadily increasing, but the technique in the related art including the metal complex dyes disclosed in US2012/0073660A and JP2009-67976A is not necessarily satisfactory.

Consequentially, the present invention aims to provide a photoelectric conversion element and a dye-sensitized solar cell having excellent performance by using a metal complex dye having excellent durability.

The present inventors examined the relationship between a ligand, which has an acidic group such as a carboxyl group for being adsorbed onto the surface of semiconductor particles, and a ligand which does not have the acidic group. As a result, they sought to improve durability by enhancing adsorptivity and focused on interactions between ligands, such as electronic interaction between ligands. In this way, the inventors obtained a clue as to the solution of the aforementioned problems and made the present invention.

That is, the object of the present invention was achieved by the following means.

(1) A photoelectric conversion element including a conductive substrate, a photosensitive layer containing an electrolyte, a charge transfer layer containing an electrolyte, and a counter electrode, in which the photosensitive layer has semiconductor particles supporting a metal complex dye represented by the following Formula (I).

M(LD)(LA)·(CI) Formula (I)

In the formula, M represents a metal ion; LD represents a ligand represented by any of the following Formulae (DL-1) to (DL-4); LA represents a ligand represented by the following Formula (AL-1) or (AL-2); and CI represents a counter ion necessary for neutralizing a charge.

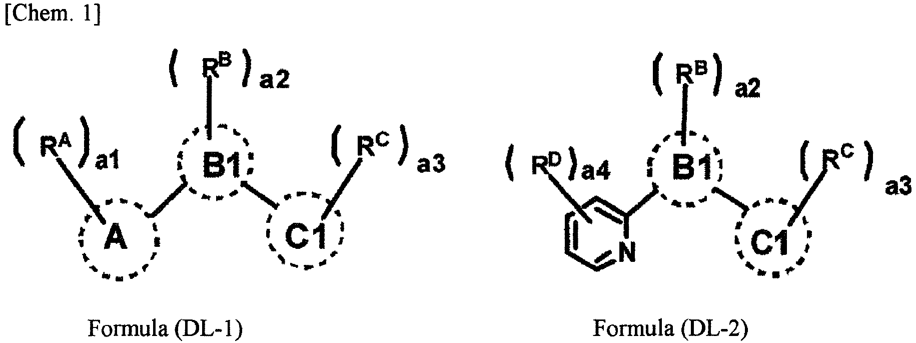

In the formulae, each of a ring A and a ring C1 independently represents any of a pyrazol ring that binds to the metal ion M through a nitrogen atom, a pyrrol ring, an imidazole ring that binds to the metal ion M through a nitrogen atom, an oxazole ring, a thiazole ring, an oxadiazole ring, a thiadiazole ring, an isoxazole ring, an isothiazole ring, a triazole ring, a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, a pyrazole ring that binds to the metal ion M through a carbon atom, and an imidazole ring that binds to the metal ion M through a carbon atom. A ring B1 represents any of a pyrimidine ring, a triazine ring, an imidazole ring that binds to the metal ion M through a nitrogen atom, an imidazole ring that binds to the metal ion M through a carbon atom (carbene), an oxazole ring, a thiazole ring, an oxadiazole ring, a thiadiazole ring, a triazole ring, and a pyrazole ring. Each of R^{A} to R^{D} independently represents a substituent. Each of a1 to a3 independently represents an integer of equal to or greater than 0, and a4 represents an integer of 0 to 4. When each of R^{A} to R^{D} is present in plural numbers, they may form a ring by binding to each other.

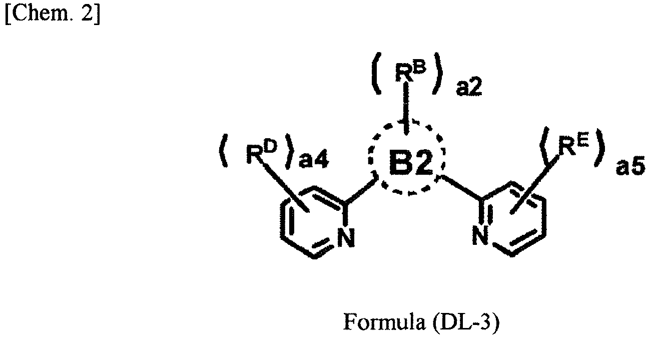

In the formula, a ring B2 represents any of a pyrimidine ring, a triazine ring, an imidazole ring that binds to the metal ion M through a nitrogen atom, an imidazole ring that binds to the metal ion M through a carbon atom (carbene), an oxazole ring, a thiazole ring, an oxadiazole ring, a thiadiazole ring, a triazole ring, a pyrazole ring, a pyrrole ring that binds to the metal ion M through a carbon atom, and a non-aromatic heterocyclic ring. Each of R^{B}, R^{D}, and R^{E} independently represents a substituent. a2 represents an integer of equal to or greater than 0, and each of a4 and a5 independently represents an integer of 0 to 4. When each of R^{B}, R^{D}, and R^{E} is present in plural numbers, they may form a ring by binding to each other.

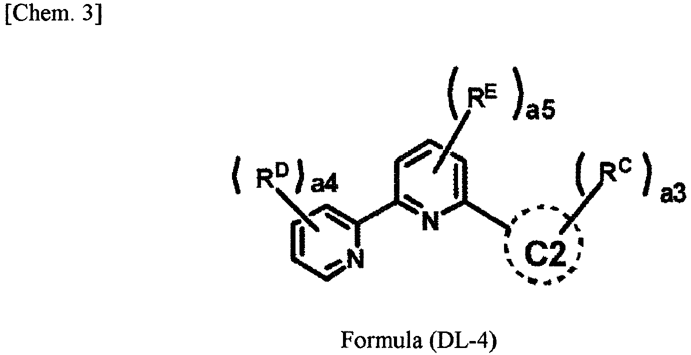

In the formula, a ring C2 represents any of a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, an imidazole ring, an oxazole ring, a thiazole ring, an oxadiazole ring, a thiadiazole ring, an isoxazole ring, an isothiazole ring, a triazole ring, a pyrazole ring, and a pyrrole ring. Each of R^{C}, R^{D}, and R^{E} independently represents a substituent. a3 represents an integer of equal to or greater than 0, and each of a4 and a5 independently represents an integer of 0 to 4. When each of R^{C}, R^{D}, and R^{E} is present in plural numbers, they may form a ring by binding to each other.

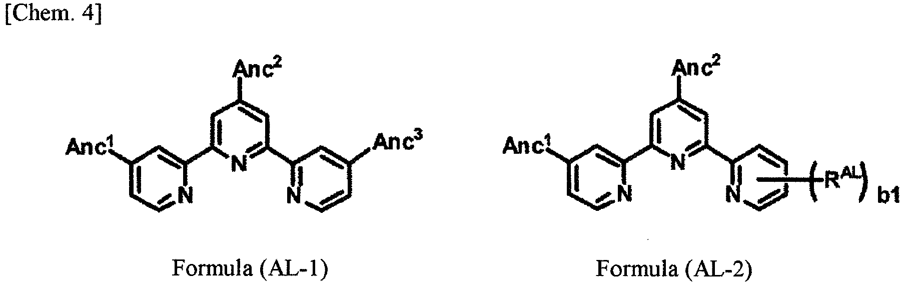

In the formulae, each of Anc¹ to Anc³ independently represents -CO₂H, -SO₃H, -PO₃H₂, or a group formed by dissociation of protons of these. R^{AL} represents a substituent, and b1 represents an integer of 0 to 4.

(2) The photoelectric conversion element descried in (1), in which M in Formula (I) is Fe²⁺, Ru²⁺, or Os²⁺.

(3) The photoelectric conversion element described in (1) or (2), in which LD in Formula (I) is represented by Formula (DL-1) or (DL-2); each of the ring A and the ring C1 independently represents any of a pyrazole ring that binds to the metal ion M through a nitrogen atom, a pyrrole ring, a pyridine ring that binds to the metal ion M through a carbon atom, a thiophene ring that binds to the metal ion M through a carbon atom, a furan ring that binds to the metal ion M through a carbon atom, and a pyrazole ring that binds to the metal ion M through a carbon atom; and the ring B1 is either a pyrimidine ring or a triazine ring.

(4) The photoelectric conversion element described in (1) or (2), in which LD in Formula (I) is represented by Formula (DL-3), and the ring B2 is a triazole ring or a non-aromatic nitrogen-containing heterocyclic ring.

(5) The photoelectric conversion element described in (1) or (2), in which LD in Formula (I) is represented by Formula (DL-4), and the ring C2 is any of a pyrrole ring, a pyridine ring that binds to the metal ion M through a carbon atom, a thiophene ring that binds to the metal ion M through a carbon atom, a furan ring that binds to the metal ion M through a carbon atom, and a pyrazole ring that binds to the metal ion M through a carbon atom.

(6) The photoelectric conversion element described in any of (1) to (5), in which LA in Formula (I) is represented by Formula (AL-1).

(7) The photoelectric conversion element described in any of (1) to (5), in which LA in Formula (I) is represented by Formula (AL-2).

(8) The photoelectric conversion element described in any of (1) to (7), in which the semiconductor particles are further loaded with a coadsorbent having one or more acidic groups.

(9) The photoelectric conversion element described in (8), in which the coadsorbent is represented by the following Formula (CA).

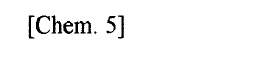

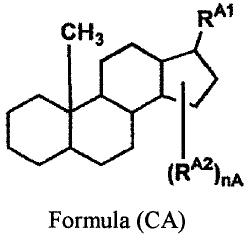

In the formula, R^{A1} represents a substituent having an acidic group; R^{A2} represents a substituent, and nA represents an integer of equal to or greater than 0.

(10) A dye-sensitized solar cell including the photoelectric conversion element described in any of (1) to (9).

In the present specification, regarding a carbon-carbon double bond, when an E-isomer and a Z-isomer are present in a molecule, unless otherwise specified, the double bond may form either the E-isomer or the Z-isomer, or form a mixture thereof. When there is a plurality of substituents, linking groups, ligands, and the like (hereinafter, referred to as "substituents and the like") marked with a specific sign, or when the plurality of substituents and the like are specified collectively or selectively, unless otherwise specified, the substituents and the like may be the same as or different from each other. The same will be applied to the case of specifying the number of the substituents and the like. Furthermore, when the plurality of substituents are close to each other (particularly, when they are adjacent to each other), unless otherwise specified, the substituents may form a ring by binding to each other. Moreover, rings, for example, an alicyclic ring, an aromatic ring, or a heterocyclic ring may form a condensed ring by being further condensed.

In the present invention, unless otherwise specified, each of the substituents may be further substituted with a substituent.

According to the present invention, it is possible to provide a photoelectric conversion element and a dye-sensitized solar cell having excellent performance by using a metal complex dye having excellent durability.

### BRIEF DESCRIPTION OF THE DRAWINGS

Fig. 1 is a cross-sectional view schematically showing an embodiment of a photoelectric conversion element of the present invention, including an enlarged view showing the interior of the layer.
Fig. 2 is a cross-sectional view schematically showing a dye-sensitized solar cell including a second embodiment of the photoelectric conversion element of the present invention.

### DESCRIPTION OF THE PREFERRED EMBODIMENTS

### «Photoelectric conversion element and dye-sensitized solar cell»

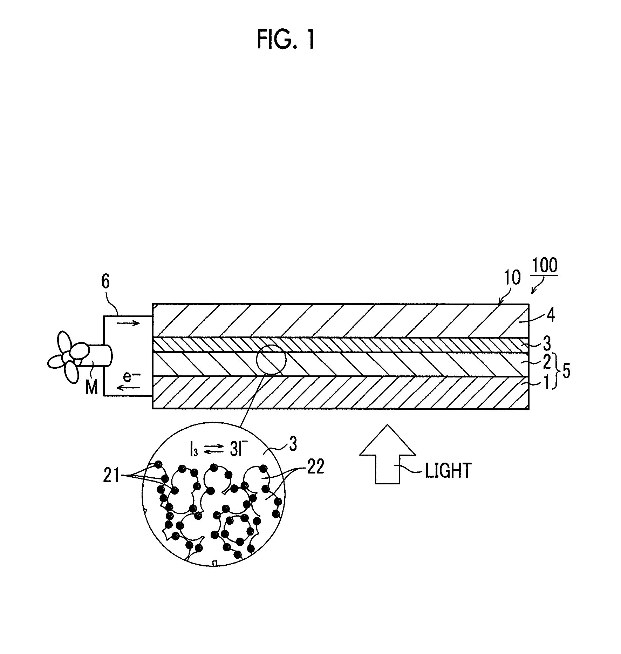

Examples of the photoelectric conversion element of the present invention include a photoelectric conversion element 10 that includes a conductive substrate 1, a photosensitive layer 2 containing semiconductor particles sensitized with a dye (metal complex dye) 21, a charge transfer layer 3 as a hole transport layer, and a counter electrode 4 as shown in Fig. 1.

In the present invention, it is preferable for the dye (metal complex dye) 21 and a coadsorbent to be adsorbed onto semiconductor particles 22. The conductive substrate 1, in which the photosensitive layer 2 is installed, functions as a working electrode in the photoelectric conversion element 10. In the present embodiment, the photoelectric conversion element 10 is described in the form of a system 100 using a dye-sensitized solar cell which can be obtained when the photoelectric conversion element 10 is used as a battery that makes operating means M work through an external circuit 6.

In the present embodiment, a light-receiving electrode 5 is composed of the conductive substrate 1 and the photosensitive layer 2 containing semiconductor particles onto which the dye (metal complex dye) 21 has been adsorbed. The photosensitive layer 2 is designed according to the purpose, and may be constituted with a single layer or multiple layers. A single photosensitive layer may contain one kind of the dye (metal complex dye) 21 or a mixture of plural kinds of the dye. However, at least one kind among the dyes used is the aforementioned metal complex dye. The light that has entered the photosensitive layer 2 excites the dye (metal complex dye) 21. The excited dye has electrons having high energy. The electrons are transferred to the conduction band of the semiconductor particles 22 from the dye (metal complex dye) 21 and then reach the semiconductor supporter 1 by diffusion. At this time, although the dye (metal complex dye) 21 has turned into an oxidized dye, electrons on the electrode work in the external circuit 6, passes the counter electrode 4, and return to the photosensitive layer 2 in which the oxidized dye (metal complex dye) 21 and an electrolyte are present. In this way, the photoelectric conversion element functions as a solar cell.

In the present invention, as materials used in the photoelectric conversion element or the dye-sensitized solar cell and methods for preparing each of the members, the materials and methods for preparing each of the members that are generally used for photoelectric conversion elements and dye-sensitized solar cells may be adopted. For example, US4927721A, US4684537A, US5084365A, US5350644A, US5463057A, US5525440A, JP1995-249790A (JP-H07-249790A), JP2004-220974A, and JP2008-135197A can be referred to. Hereinafter, main members will be schematically described.

### <Photosensitive layer>

The photosensitive layer is a layer that contains an electrolyte, which will be described later, and semiconductor particles supporting a sensitizing dye including the metal complex dye used in the present invention described below.

### «Metal complex dye»

The metal complex dye used in the present invention is represented by the following Formula (I).

M(LD)(LA)·(CI) Formula (1)

In the formula, M represents a metal ion; LD represents a ligand represented by any of the following Formulae (DL-1) to (DL-4); LA represents a ligand represented by the following Formula (AL-1) or (AL-2); and CI represents an ion necessary for neutralizing a charge.

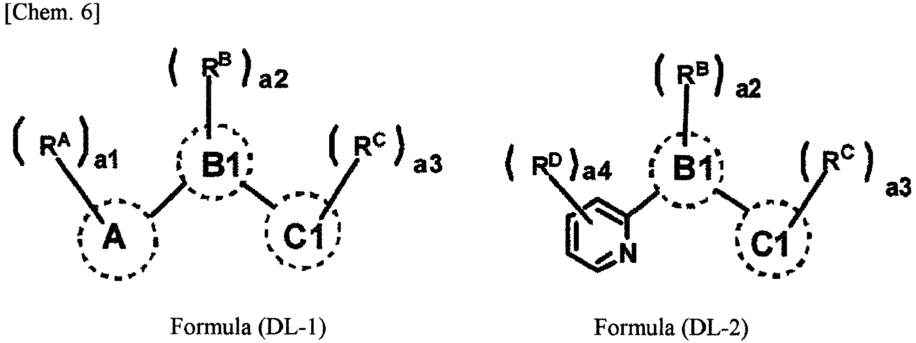

In the formulae, each of a ring A and a ring C1 independently represents any of a pyrazol ring that binds to the metal ion M through a nitrogen atom, a pyrrol ring, an imidazole ring that binds to the metal ion M through a nitrogen atom, an oxazole ring, a thiazole ring, an oxadiazole ring, a thiadiazole ring, an isoxazole ring, an isothiazole ring, a triazole ring, a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, a pyrazole ring that binds to the metal ion M through a carbon atom, and an imidazole ring that binds to the metal ion M through a carbon atom. A ring B 1 represents any of a pyrimidine ring, a triazine ring, an imidazole ring, an imidazole ring that binds to the metal ion M through a carbon atom (carbene), an oxazole ring, a thiazole ring, an oxadiazole ring, a thiadiazole ring, a triazole ring, and a pyrazole ring. Each of R^{A} to R^{D} independently represents a substituent. Each of a1 to a3 independently represents an integer of equal to or greater than 0, and a4 represents an integer of 0 to 4. When each of R^{A} to R^{D} is present in plural numbers, they may form a ring by binding to each other.

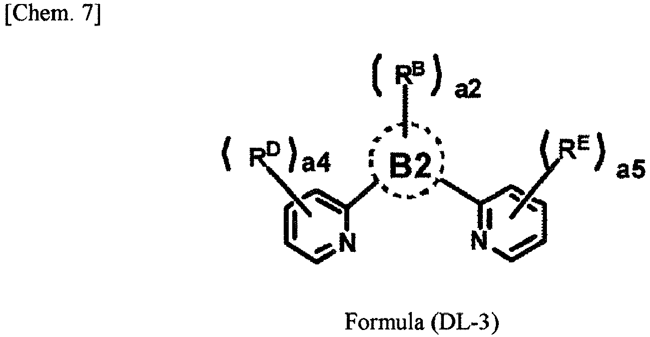

In the formula, a ring B2 represents any of a pyrimidine ring, a triazine ring, an imidazole ring that binds to the metal ion M through a nitrogen atom, an imidazole ring that binds to the metal ion M through a carbon atom (carbene), an oxazole ring, a thiazole ring, an oxadiazole ring, a thiadiazole ring, a triazole ring, a pyrazole ring, a pyrrole ring that binds to the metal ion M through a carbon atom, and a non-aromatic heterocyclic ring. Each of R^{B}, R^{D}, and R^{E} independently represents a substituent. a2 represents an integer of equal to or greater than 0, and each of a4 and a5 independently represents an integer of 0 to 4. When each of R^{B}, R^{D}, and R^{E} is present in plural numbers, they may form a ring by binding to each other.

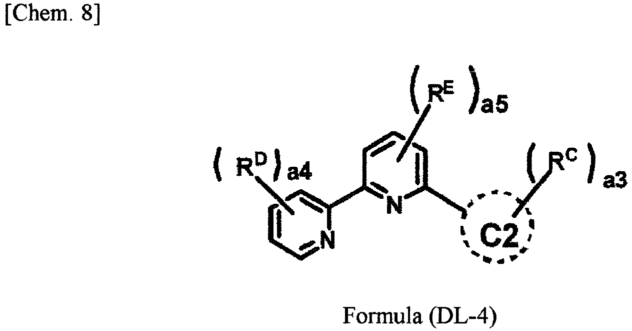

In the formula, a ring C2 represents any of a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, an imidazole ring, an oxazole ring, a thiazole ring, an oxadiazole ring, a thiadiazole ring, an isoxazole ring, an isothiazole ring, a triazole ring, a pyrazole ring, and a pyrrole ring. Each of R^{C}, R^{D}, and R^{E} independently represents a substituent. a3 represents an integer of equal to or greater than 0, and each of a4 and a5 independently represents an integer of 0 to 4. When each of R^{C}, R^{D}, and R^{E} is present in plural numbers, they may form a ring by binding to each other.

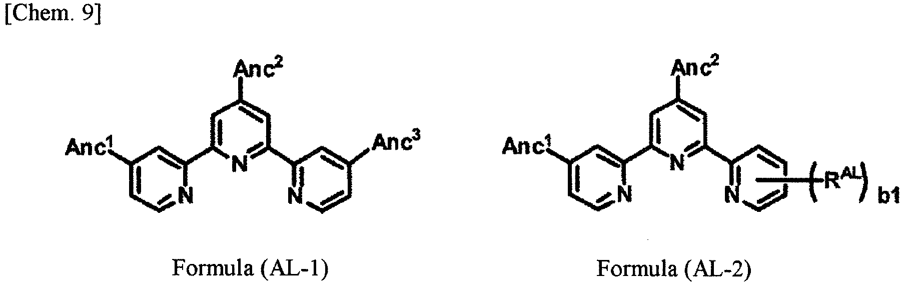

In the formulae, each of Anc¹ to Anc³ independently represents -CO₂H, -SO₃H, -PO₃H₂, or a group formed by dissociation of protons of these groups. R^{AL} represents a substituent, and b1 represents an integer of 0 to 4.

### -Metal ion M-

M represents a central metal of the metal complex dye, and examples thereof include elements of groups 6 to 12 on the long-form periodic table.

Examples of such elements include Ru, Fe, Os, Cu, W, Cr, Mo, Ni, Pd, Pt, Co, Ir, Rh, Re, Mn, and Zn.

In the present invention, M is preferably Fe²⁺, Ru²⁺, or Os²⁺, and among these, Ru²⁺ is preferable.

In the state where M is incorporated into the photoelectric conversion element, the valency of M changes in some cases due to an oxidation-reduction reaction between M and the surrounding material.

### -Ligand LD-

In the present invention, as the ligand LD, a ligand represented by any of Formulae (DL-1) to (DL-4) is used.

In view of durability, particularly, from the viewpoint of heat resistance and heat cycle properties, a ligand represented by Formula (DL-1), (DL-2), or (DL-4) is excellent. From the viewpoint of heat resistance, a ligand represented by Formula (DL-1) is preferable, and from the viewpoint of heat cycle properties, a ligand represented by Formula (DL-2) is preferable.

As is evident from Formula (I), in the metal complex dye used in the present invention, the ligand LD and the ligand LA are combined with each other to form a specific ligand structure and coordinated with the metal ion M. Herein, the ligand LA is a ligand having an acidic group that is to be adsorbed onto the surface of semiconductor particles, and the ligand LD is a ligand that is not regarded as being adsorbed onto the surface of semiconductor particles.

In the present invention, in order to improve adsorptivity of the ligand LA with respect to the surface semiconductor particles, the electronic effect of the ligand LD is adjusted. In other words, instead of the ligand LA, the ligand LD is used to adjust the adsorptivity of the acidic group of the ligand LA. In the present invention, it is considered that the use of a heterocyclic ring, which exhibit superior π electron acceptability compared to pyridine-based ligands in the related art, is effective. Moreover, it is considered that change of rings or modification of substituents is effective for inhibiting intermixing of dyes and improving a coordination ability.

As heterocyclic rings effective for achieving the above objects or as the form of linking bidentate to tridentate heterocyclic rings to each other, Formulae (DL-1) to (DL-4) are useful. Heterocyclic rings used at this time includes the heterocyclic rings, the ring A, the ring B1, the ring B2, the ring C1, and the ring C2 incorporated in Formulae (DL-1) to (DL-4).

Specifically, the rings are as follows.

### •Ring A and Ring C1.

Each of the ring A and the ring C1 represents any of a pyrazole ring that binds to the metal ion M through a nitrogen atom, a pyrrole ring, an imidazole ring that binds to the metal ion M through a nitrogen atom, an oxazole ring, a thiazole ring, an oxadiazole ring, a thiadiazole ring, an isoxazole ring, an isothiazole ring, a triazole ring, a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, a pyrazole ring that binds to the metal ion M through a carbon atom, and an imidazole ring that binds to the metal ion M through a carbon atom.

Among the above, as the ring A and the ring C1, a pyrazole ring that binds to the metal ion M through a nitrogen atom, a pyrrole ring, a pyridine ring that binds to the metal ion M through a carbon atom, a thiophene ring that binds to the metal ion M through a carbon atom, a furan ring that binds to the metal ion M through a carbon atom, and a pyrazole ring that binds to the metal ion M through a carbon atom are preferable, and a pyrazole ring that binds to the metal ion M through a nitrogen atom, a pyrrole ring, a thiophene ring that binds to the metal ion M through a carbon atom, and a pyrazole ring that binds to the metal ion M through a carbon atom are more preferable. In this case, the ring A and the ring C1 are preferably combined with a ring preferable as the following ring B1.

### • Ring B1

The ring B1 represents any of a pyrimidine ring, a triazine ring, an imidazole ring, an imidazole ring that binds to the metal ion M through a carbon atom (carbene), an oxazole ring, a thiazole ring, an oxadiazole ring, a thiadiazole ring, a triazole ring, and a pyrazole ring.

Herein, in a formula that represents the metal complex dye, carbene is indicated by two dots such as (÷) or (:) on a direct bond that carbon atoms have.

Among the above rings, the ring B 1 is preferably a pyrimidine ring or a triazine ring, and more preferably a triazine ring.

### • Ring B2

The ring B2 represents any of a pyrimidine ring, a triazine ring, an imidazole ring that binds to the metal ion M through a nitrogen atom, an imidazole ring that binds to the metal ion M through a carbon atom (carbene), an oxazole ring, a thiazole ring, an oxadiazole ring, a thiadiazole ring, a triazole ring, a pyrazole ring, a pyrrole ring that binds the the metal ion M through a carbon atom, and a non-aromatic heterocyclic ring.

Among the above rings, the ring B2 is preferably a triazole ring or a non-aromatic nitrogen-containing heterocyclic ring.

The non-aromatic nitrogen-containing heterocyclic ring is a 5- or 6-membered ring, and may be condensed with other rings (for example, a benzene ring and a aromatic nitrogen-containing heterocyclic ring). Examples thereof include a pyrolidine ring, a pyrroline ring, an imidazolidine ring, an imidazoline ring, a pyrazolidine ring, a piperidine ring, a piperazine ring, a morpholine ring, an indoline ring, an isoindoline ring, and the like, and preferable examples thereof include a 1,2-dihydroquinoline ring.

### • Ring C2

The ring C2 represents any of a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, an imidazole ring, an oxazole ring, a thiazole ring, an oxadiazole ring, a thiadiazole ring, an isoxazole ring, an isothiazole ring, a triazole ring, a pyrazole ring, and a pyrrole ring.

Among the above rings, the ring C2 is preferably a pyrrole ring, a pyridine ring that binds to the metal ion M through a carbon atom, a thiophene ring that binds to the metal ion M through a carbon atom, a furan ring that binds to the metal ion M through a carbon atom, or a pyrazole ring that binds to the metal ion M through a carbon atom.

These rings may have a substituent, and are represented by R^{A} to R^{E} respectively in Formulae (DL-1) to (DL-4).

Examples of the substituents in R^{A} to R^{E} include the substituents exemplified in the section of substituents T which will be described later.

As the substituents, a halogen atom, an alkyl group (a substituted alkyl group is also preferable; for example, a perfluoroalky group, and preferably, a trifluoromethyl group), an ethynyl group (preferably having an aryl group or a heteroaryl group in 2-position (preferably a phenyl group or a monovalent thiophene ring group; among these, a 2-thienyl group is preferable), an ethenyl group (preferably having an aryl group or a heteroaryl group in 2-position (preferably a phenyl group or a monovalent thiophene ring group; among these, a 2-thienyl group is preferable), and alkoxy group, an aryloxy group, an alkylthio group, an arylthio group, an alkylamino group, an arylamino group, a heterocyclic amino group (for example, piperazinyl, indolinyl, 1-morpholinyl, and 1-piperidinyl), an aryl group, and an aromatic heterocyclic group are preferable.

As the aryl group, a phenyl group which may have a substituent is preferable. As the heterocyclic cyclic ring of the aromatic heterocyclic group, a thiophene ring and a furan ring are preferable, and a thiophene ring is more preferable.

Herein, the aryl group and the aromatic heterocyclic group may further have a substituent, and in this case, it is preferable for the aryl group and the aromatic heterocyclic group to have the substituent in a ring-constituting atom adjacent to an atom of a direct bond or in an atom adjacent to the atom adjacent to the atom of the direct bond. For example, a phenyl group has a substituent in an ortho-position or a meta-position of a direct bond, and particularly preferably has a substituent in an ortho-position.

Regarding the substituent, the total number of carbon atoms constituting a single substituent is preferably 6 to 26, more preferably 6 to 20, and even more preferably 8 to 20.

Any of R^{A} to R^{E} may be a group represented by the following Formula (U1) or (U2).

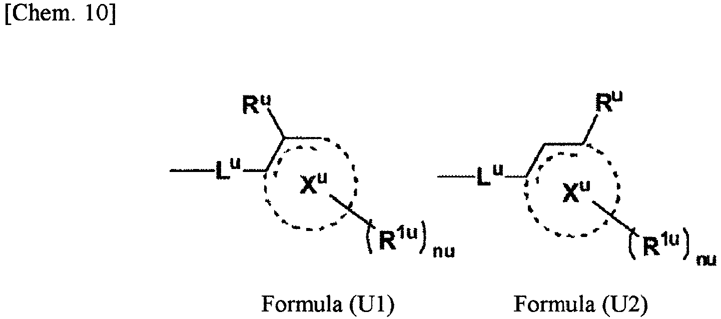

In the formulae, a ring X^{u} represents a group in the form of a 5-membered ring or a 6-membered ring. Each of R^{u} and R^{1u} independently represents a substituent. nu represents an integer of 0 to 4. Here, R^{u} and R^{1u} do not form a ring by binding to each other. Herein, the dashed line, which is described between an atom of a direct bond of the aforementioned group and the position to which R^{u} binds, shows that the portion may be a single bond or a double bond. The ring X^{u} is preferably a thiophene ring or a benzene ring.

Among groups represented by Formulae (U1) and (U2), the group represented by Formula (U1) is preferable.

L^{u} represents an ethenylene group, an ethynylene group, an arylene group, or a heteroarylene group. Herein, the arylene group is a divalent aromatic carbocyclic group, and examples thereof include phenylene and naphthylene. Examples of ring-constituting heteroatoms of a heteroaryl ring in the heteroarylene group include an oxygen atom, a sulfur atom (-S-, -SO-, or -SO₂-), a nitrogen atom, a silicon atom, and a selenium atom. The ring may be constituted with 5 to 7 members and condensed with an alicyclic ring, an aromatic ring, or a heterocyclic ring. Examples of such the ring include a thiophene ring, a benzothiophene ring, a furan ring, and a pyridine ring.

Among the substituents represented by R^{u}, linear or branched alkyl group, cycloalkyl group, alkoxy group, cycloalkoxy group, alkylthio group, cycloalkylthio group, amino group, alkylamino group, cycloalkylamino group, and arylamino group are preferable; linear or branched alkyl group, cycloalkyl group, alkoxy group, cycloalkoxy group, alkylamino group, cycloalkylamino group, and aryl amino group are more preferable; linear or branched alkyl group, alkoxy group, and alkylamino group are even more preferable; and linear or branched alkyl group and alkoxy group are particularly preferable.

Specific examples of the ring A, the ring C1, and the ring C2 will be shown below, but the present invention is not limited thereto.

Herein, "-" present in the ring represents a direct bond.

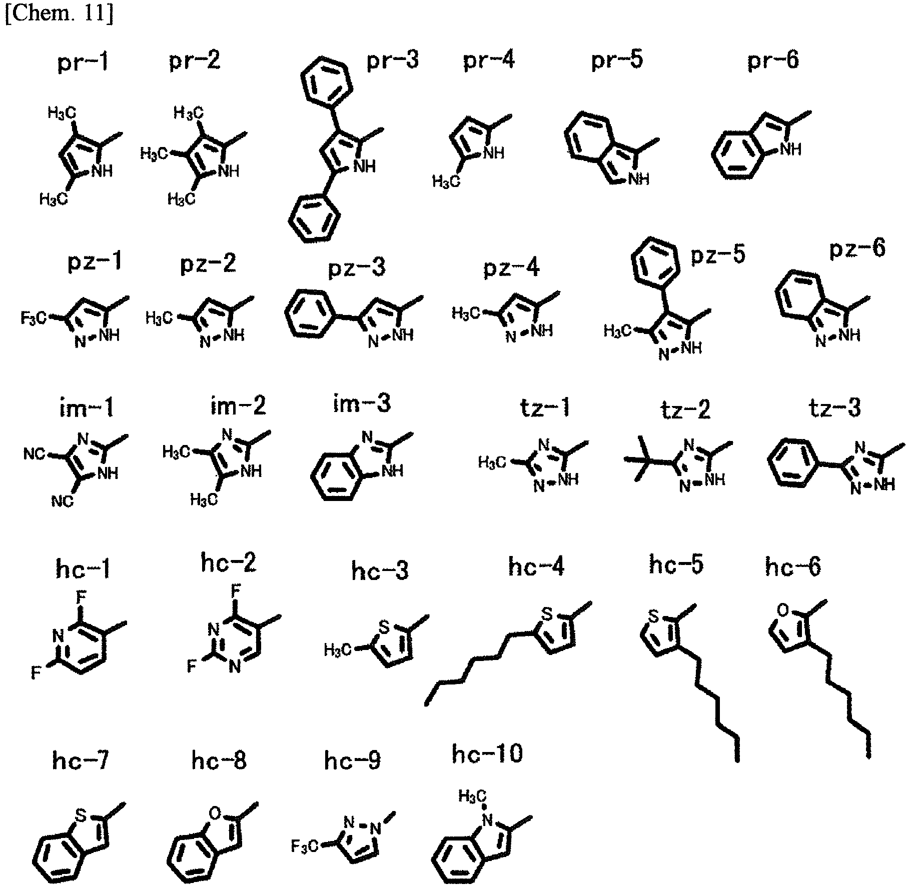

Among these, in pr-1 to pr-6, pz-1 to pz-6, im-1 to im-3, and tz-1 to tz-3, nitrogen atoms having undergone proton dissociation bind to M. Here, in tz-1 to tz-3, other nitrogen atoms may bind to or be coordinated with the metal ion M in the form of a tautomer. hc-1 to hc-10 bind to or be coordinated with the metal ion M through a carbon atom. The ring A and the ring C1 may be the same as or different from each other.

Specific examples of the ring B1 and the ring B2 will be shown below, but the present invention is not limited thereto.

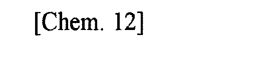

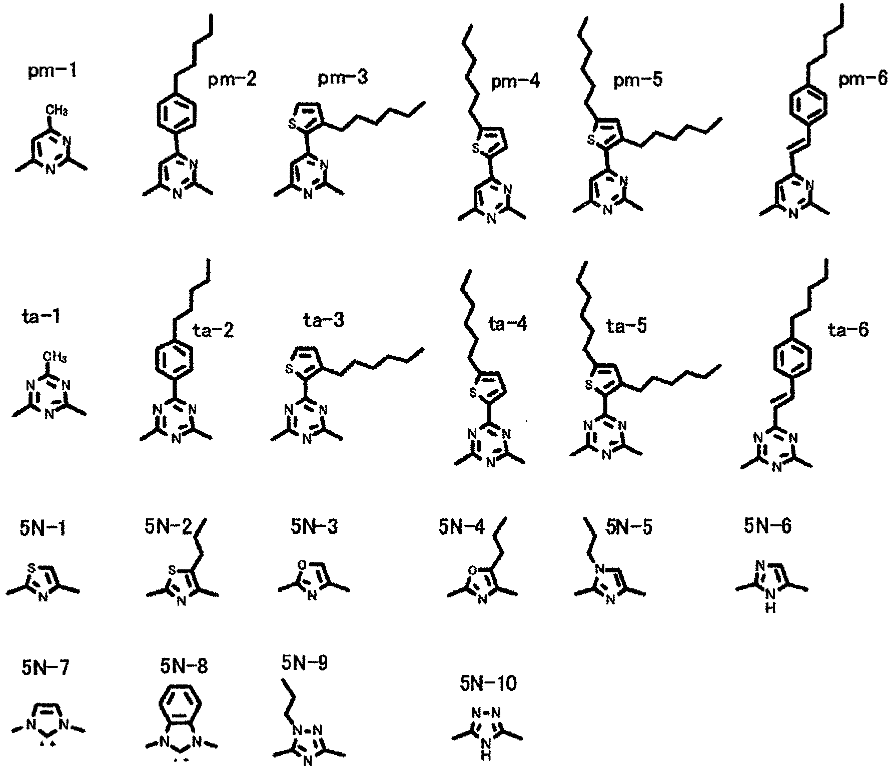

Herein, in 5N-6 and 5N-10, nitrogen atoms having undergone proton dissociation bind to the metal ion M. 5N-7 and 5N-8 binds to the metal ion M through a carbon atom (carbene).

In Formulae (DL-1) to (DL-4), a1 to a3 represent 0 or an integer of equal to or greater than 1, preferably represent an integer of 0 to 2, and more preferably represent 0 or 1.

a4 and a5 preferably represent an integer of 0 to 2, and more preferably represent 0 or 1.

In Formulae (DL-1) to (DL-4), any of three rings preferably has a substituent. When a plurality of rings has a substituent, a case in which each of three rings has a substituent, a case in which each of two rings has a substituent, and a case in which only one ring has a substituent are preferable. When the ring has a substituent, a case in which the central ring among the three rings has a substituent is most preferable.

### -Ligand LA-

In the present invention, the ligand LA is a ligand which is represented by Formula (AL-1) or (AL-2) and has at least one substituent.

In Formulae (AL-1) and (AL-2), each of Anc¹ to Anc³ represents -CO₂H, -SO₃H, -PO₃H₂, or a group formed by dissociation of protons of these groups.

Herein, the group formed by the dissociation of protons includes the aforementioned anions or salts thereof. In order to be coordinated with the metal ion M, anions are preferable, and examples thereof include -CO₂⁻, -SO₃⁻, -PO₃H⁻, and -PO₃²⁻.

In the present invention, -CO₂H or a group formed by dissociation of protons thereof is preferable.

In Formulae (AL-1) and (AL-2), R^{AL} represents a substituent, and examples of the substituent include the substituents T which will be described later.

R^{AL} is preferably an alkyl group, a cycloalkyl group, an ethynyl group, an ethenyl group, an aryl group, or an aromatic heterocyclic group. Herein, the aromatic heterocyclic group is preferably a thienyl group or a furanyl group, and more preferably a thienyl group.

b1 represents an integer of 0 to 4, preferably represents 0 or 1, and more preferably represents 1.

### -Counter ion CI for neutralizing a charge-

CI represents a counter ion used when a counter ion is required for neutralizing a charge. Generally, whether the dye is a cation or an anion or whether a dye carries net ionic charge depends on the metal, ligand, and substituent in the metal complex dye.

When the substituent has a dissociable group, the metal complex dye may be dissociated and carry negative charge. In this case, the charge of the entire metal complex dye becomes electrically neutral due to CI.

When the counter ion CI is a positive counter ion, the counter ion CI is, for example, an inorganic or organic ammonium ion (such as a tetraalkylammonium ion, a pyridinium ion, or the like), a phosphonium ion (such as a tetraalkylphosphonium ion, alkyltriphenyl phosphonium ion, or the like), an alkali metal ion, a metal complex ion, or a proton. As the positive counter ion, an inorganic or organic ammonium ion (a triethylammonium ion, a tetrabutylammonium ion, or the like) and a proton are preferable.

When the counter ion CI is a negative counter ion, the counter ion CI may be an inorganic anion or an organic anion. Examples thereof include a hydroxide ion, a halogen anion (such as a fluoride ion, a chloride ion, a bromide ion, or an iodide ion), a substituted or unsubstituted alkyl carboxylate ion (such as acetate ion, trifluoroacetic acid, or the like), a substituted or unsubstituted aryl carboxylate ion (such as benzoate ion), a substituted or unsubstituted alkylsulfonate ion (such as a methanesulfonate ion or a trifluoromethanesulfonate ion), a substituted or unsubstituted arylsulfonate ion (such as a p-toluenesulfonate ion or a p-chlorobenzenesulfonate ion), an aryldisulfonate ion (such as a 1,3-benzenedisulfonate ion, a 1,5-naphthalenedisulfoante ion, or a 2,6-naphthalenedisulfonate ion), an alkylsulfate ion (such as methylsulfate ion), a sulfate ion, a thiocyanate ion, a perchlorate ion, a tetrafluoroborate ion, a hexafluorophosphate ion, and a picrate ion. Furthermore, as a charge balancing counter ion, either an ionic polymer or other dyes carrying charge opposite to the charge of the dye may be used. Moreover, it is possible to use a metal complex ion (such as bisbenzene-1,2-dithiolatonickel (III)). As the negative counter ion, a halogen anion, a substituted or unsubstituted alkylcarbocylate ion, a substituted or unsubstituted alkylsulfonate ion, a substituted or unsubstituted arylsulfonate ion, an aryldisulfonate ion, a perchlorate ion, and a hexafluorophosphate ion are preferable, and a halogen anion and a hexafluorophosphate ion are more preferable.

Specific examples of the metal complex dye used in the present invention will be shown below, but the present invention is not limited thereto. In the following structure, CI in Formula (I) is described as a proton, but it may be a tetrabutylammonium ion (⁺NBu₄), a sodium ion, or the like.

Furthermore, in the following structure, in the metal complex dye in which at least one of Anc¹ to Anc³ is described as -COO, the -COO may turn into -COOH and has a negative counter ion. Examples of the negative counter ion include the aforementioned negative counter ions.

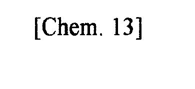

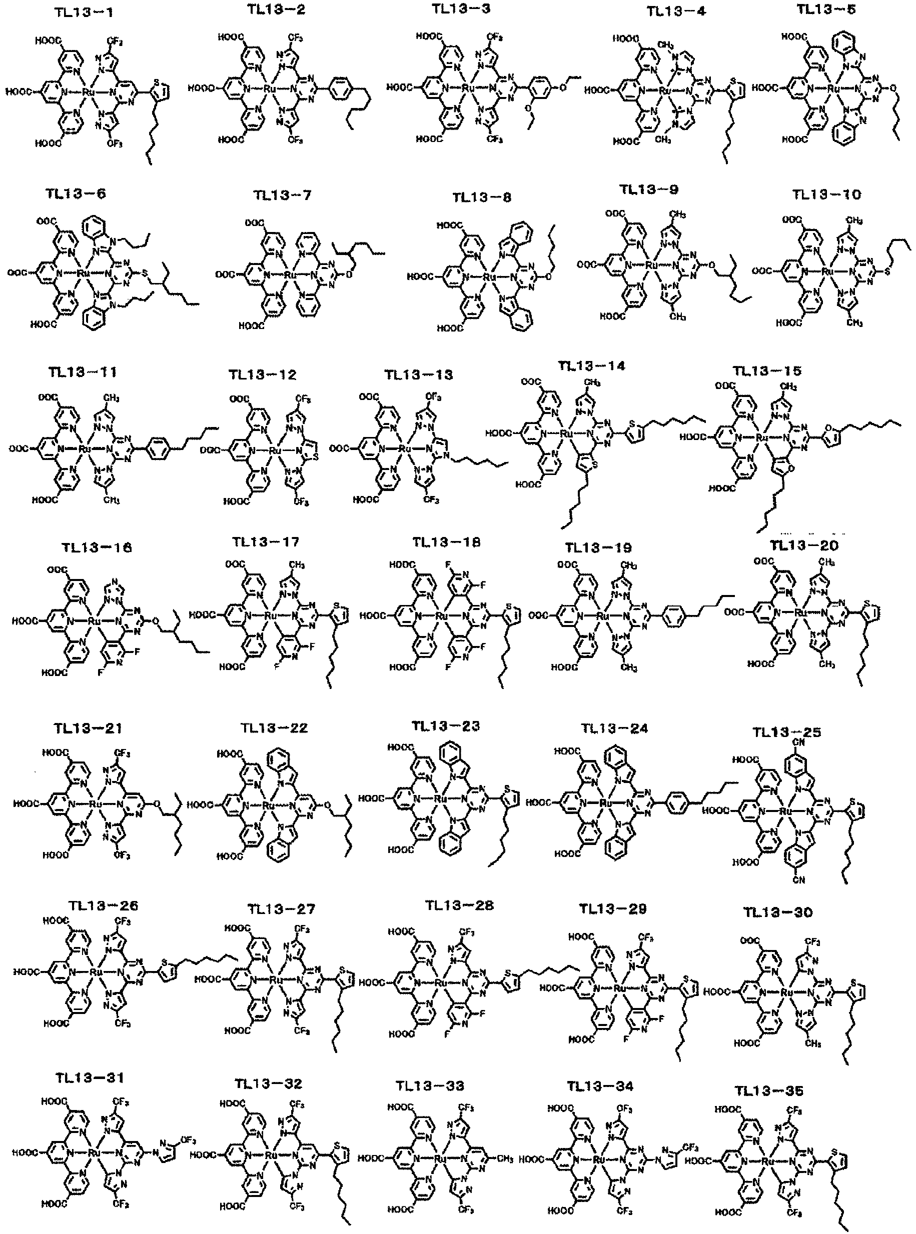

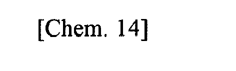

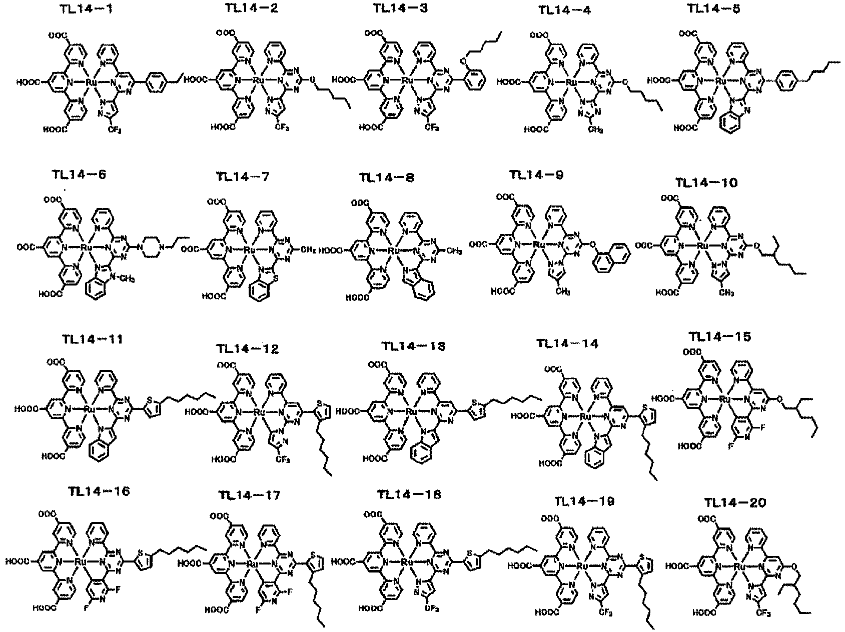

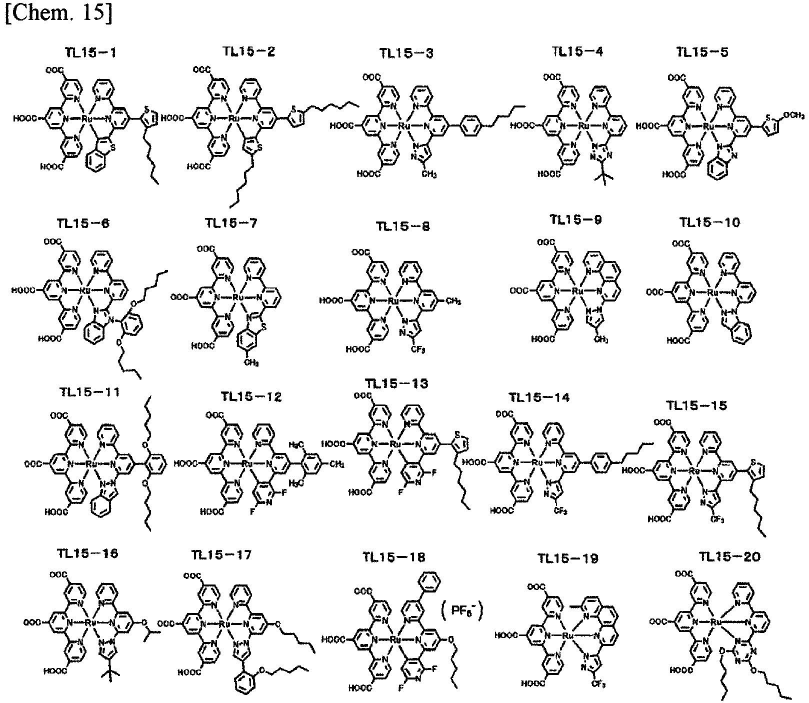

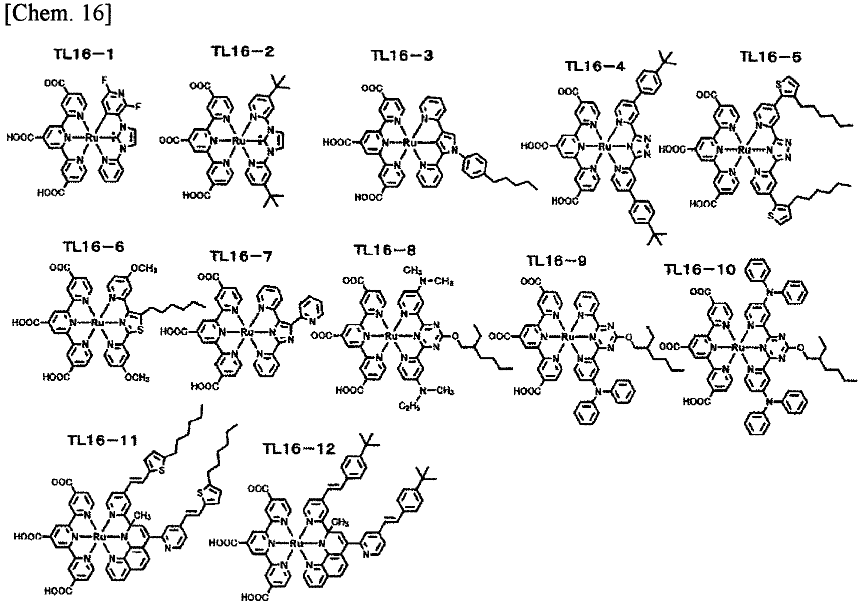

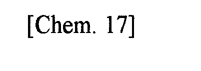

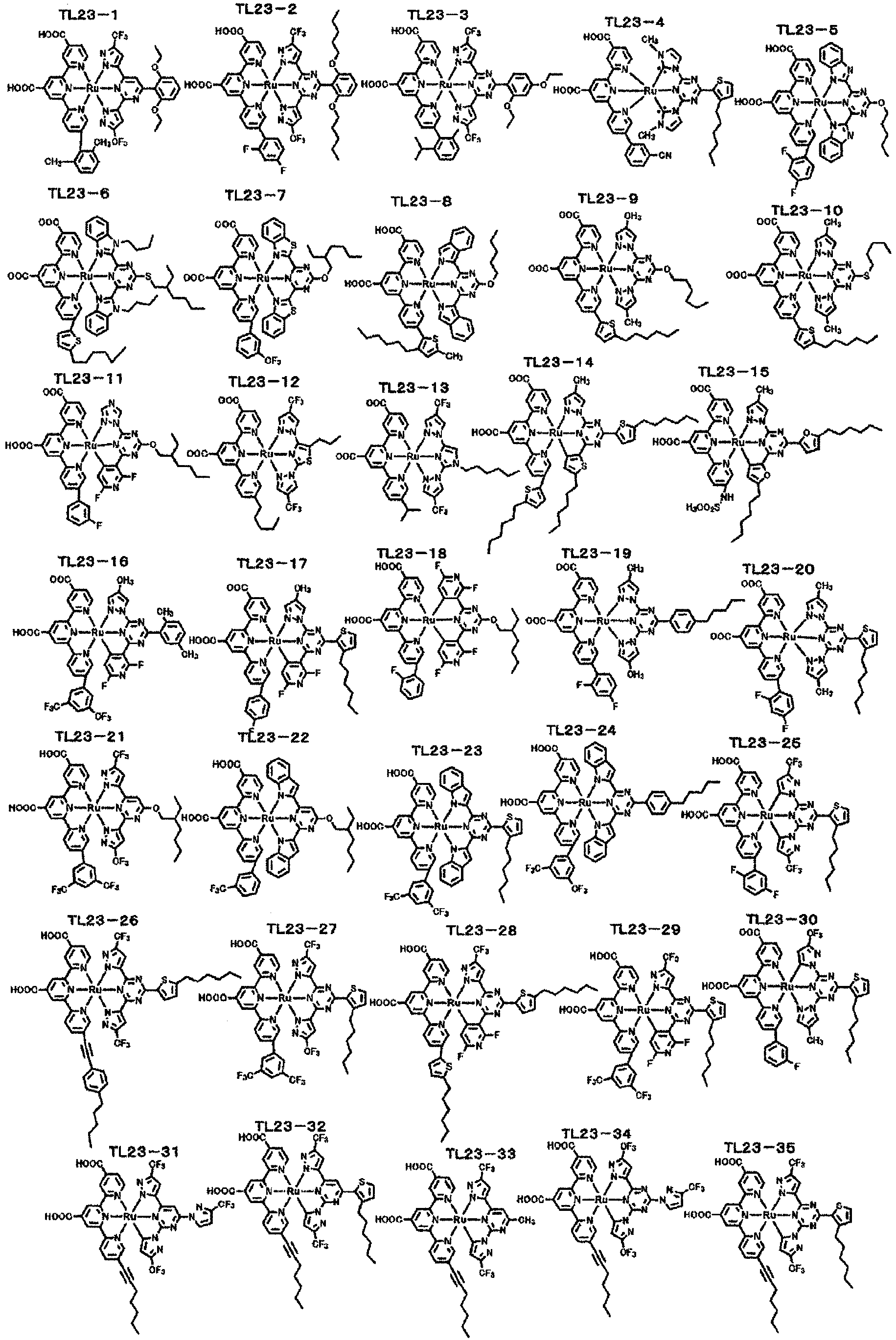

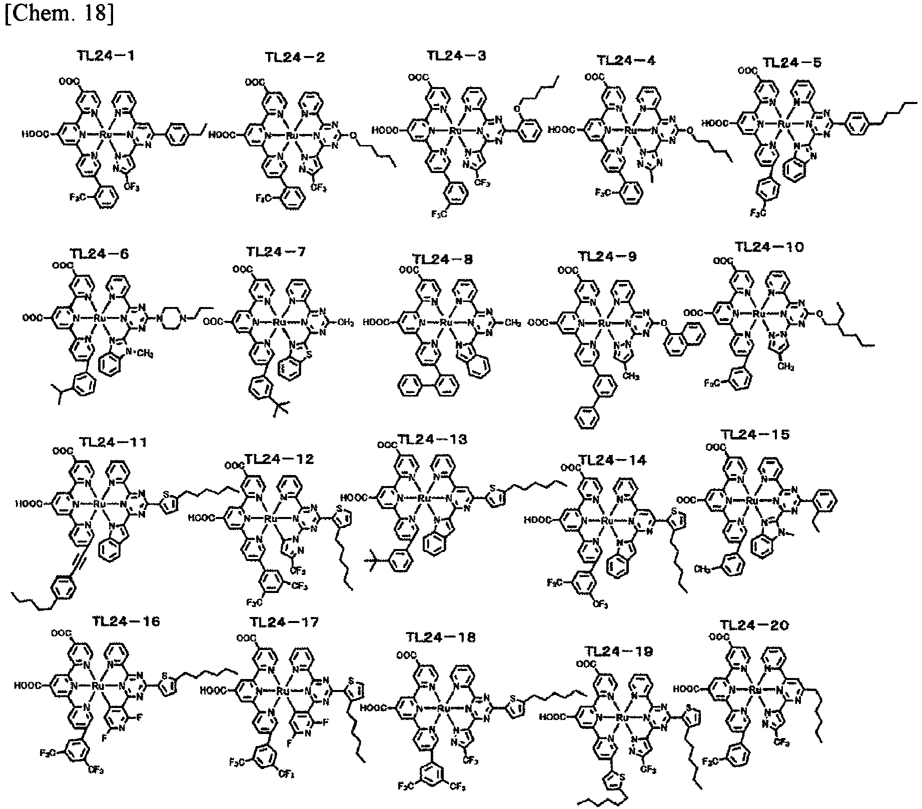

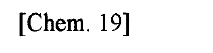

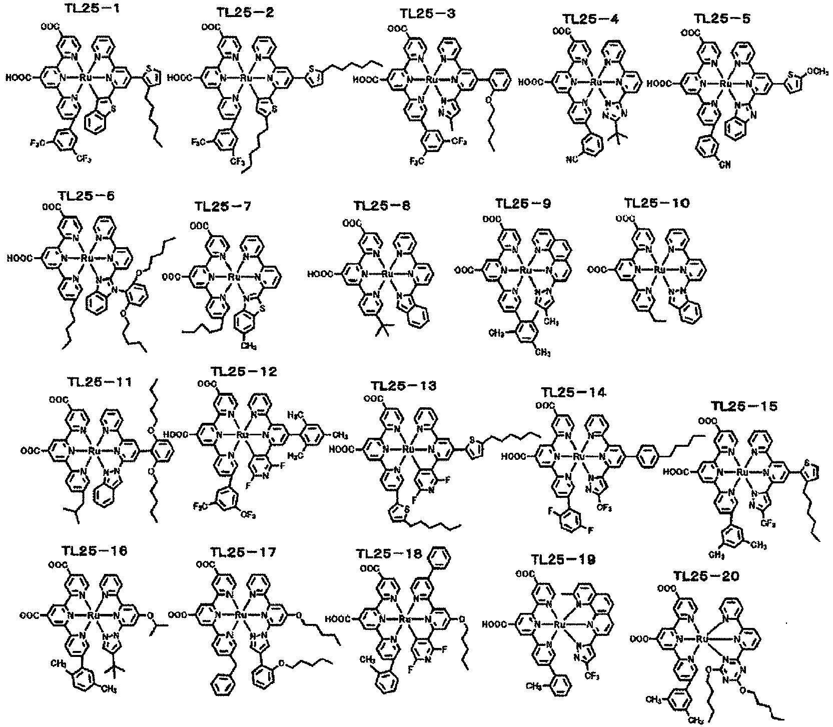

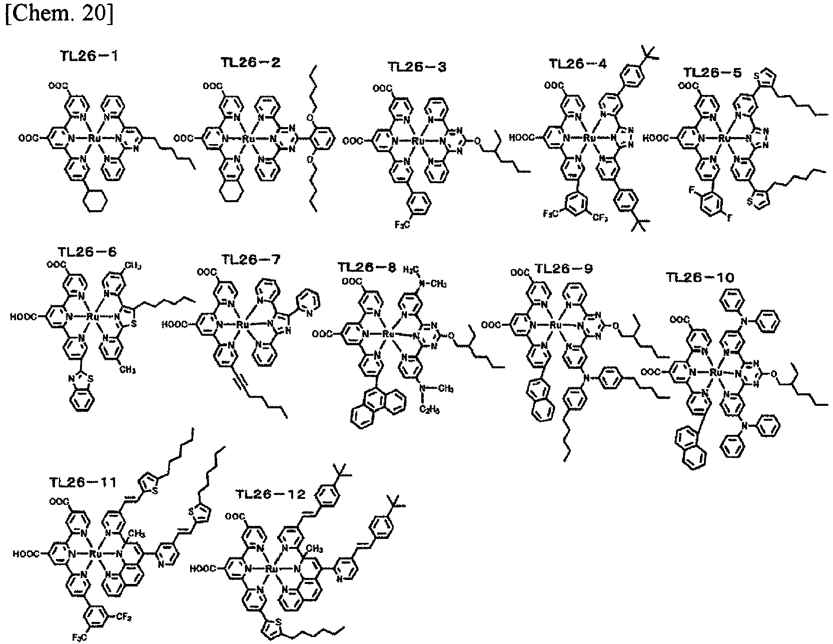

The metal complex dye used in the present invention can be easily synthesized by the methods based on the methods described in Chemistry-A European Journal, 17(39), 10871 to 10878 (2011), Angewandte Chemie, 84, 824 to 826 (1972), and Dalton Transactions, 5, 770 to 772 (2009), the method based on the method described in JP2001-291534A or the method cited in this document, or by the method based on the method described in Angew. Chem. Int. Ed., 50, 2054 to 2058 (2011).

A maximum absorption wavelength in a solution of the metal complex dye used in the present invention is preferably within a range of 300 nm to 1,000 nm, more preferably within a range of 350 nm to 950 nm, and particularly preferably within a range of 370 nm to 900 nm.

### -Conductive substrate-

The conductive substrate is preferably a metal supporter having conductivity. Alternatively, it is preferably a glass or plastic supporter having a conductive film layer on the surface. Examples of the plastic supporter include the transparent polymer film described in paragraph [0153] of JP2001-291534A. As the supporter, in addition to glass or plastic, ceramics (JP2005-135902A) and conductive resins (JP2001-160425A) may be used. A light management function may be added to the surface of the conductive substrate. For example, the conductive substrate may have an antireflection film described in JP2003-123859A that is obtained by alternately laminating a high-refractive index film and a low-refractive index oxide film, or may have a light guide function described in JP2002-260746A.

The thickness of the conductive film layer is preferably 0.01 µm to 30 µm, more preferably 0.03 µm to 25 µm, and particularly preferably 0.05 µm to 20 µm.

It is preferable for the conductive substrate to be substantially transparent. If the conductive substrate is "substantially transparent", it means that the light transmittance thereof is equal to or greater than 10%. The light transmittance is preferably equal to or greater than 50%, and particularly preferably equal to or greater than 80%. As the transparent conductive substrate, a supporter obtained by coating glass or plastic with a conductive metal oxide is preferable. As the metal oxide, tin oxide is preferable, and indium tin oxide and a fluorine-doped oxide are particularly preferable. At this time, the amount of the conductive metal oxide used for coating is preferably 0.1 g to 100 g per 1 m² of the glass or plastic supporter. When the transparent conductive substrate is used, it is preferable to allow light to enter from the supporter side.

### -Semiconductor particles-

The semiconductor particles are preferably particles of chalcogenide (such as an oxide, a sulfide, or selenide) of a metal or particles of Perovskite. Preferable examples of the chalcogenide of a metal include titanium, tin, zinc, tungsten, zirconium, hafnium, strontium, indium, cerium, yttrium, lanthanum, vanadium, niobium, an oxide of tantalum, cadmium sulfide, cadmium selenide, and the like. Preferable examples of Perovskite include strontium titanate, calcium titanate, and the like. Among these, titanium oxide (titania), zinc oxide, tin oxide, and tungsten oxide are particularly preferable.

Examples of the crystal structure of titania includes an anatase type, a Brukite-type, and a rutile-type, and among these, an anatase-type and a Brukite-type are preferable. Titania nanotubes, titania nanowires, or titania rods may be mixed with titania particles or used as a semiconductor electrode.

The particle size of the semiconductor particles is a mean particle size obtained by using a diameter determined when the projected area of the particles is converted into a circle. The particle size is preferably 0.001 µm to 1 µm in terms of a primary particle size, and preferably 0.01 µm to 100 µm in terms of a mean particle size of a dispersion. Examples of the method of coating the conductive substrate with semiconductor particles include a wet method, a dry method, and other methods.

In order to prevent reverse current caused by direct contact between the electrolyte and the electrode, it is preferable to form a short circuit-preventing layer between the transparent conductive film and the semiconductor layer (photosensitive layer). Moreover, in order to prevent contact between the photoelectrode and the counter electrode, it is preferable to use a spacer or a separator. It is preferable for the semiconductor particles to have a large surface area such that the particles can adsorb a large amount of dye. For example, in a state in which the supporter is coated with the semiconductor particles, the surface area is preferably not less than 10 times the projected area, and more preferably not less than 100 times the projected area. The upper limit thereof is not particularly limited, but usually, the surface area is about 5,000 times the projected area. Generally, the greater the thickness of the layer containing the semiconductor particles, the larger the amount of the dye that can be supported per unit area, and consequentially, light absorption efficiency is improved. However, because the generated electrons are diffused farther away, the loss resulting from charge recombination also increases. Typically, the thickness of the photosensitive layer as a semiconductor layer is preferably 0.1 µm to 100 µm, although the thickness varies with the use of the element. When the photoelectric conversion element is used as a dye-sensitized solar cell, the thickness is preferably 1 µm to 50 µm, and more preferably 3 µm to 30 µm. After the supporter is coated with the semiconductor particles, the semiconductor particles may be fired at a temperature of 100°C to 800°C for 10 minutes to 10 hours, such that the particles come into close contact with each other. When glass is used as the supporter, the film formation temperature is preferably 60°C to 400°C.

The amount of the semiconductor particles used for coating is preferably 0.5 g to 500 g and more preferably 5 g to 100 g per 1 m² of the supporter. The amount of the dye used is preferably 0.01 mmol to 100 mmol, more preferably 0.1 mmol to 50 mmol, and particularly preferably 0.1 mmol to 10 mmol per 1 m² of the supporter. In this case, the amount of the metal complex dye used in the present invention is preferably equal to or greater than 5 mol%. Furthermore, the amount of the dye adsorbed onto the semiconductor particles is preferably 0.001 mmol to 1 mmol and more preferably 0.1 mmol to 0.5 mmol with respect to 1 g of the semiconductor particles. If the amount of the dye is within the above range, a sensitizing effect in the semiconductor particles is sufficiently obtained.

When the dye is a salt, the counter ion of the aforementioned specific metal complex dye is not particularly limited, and examples of the counter ion include an alkali metal ion, a quaternary ammonium ion, and the like.

After the dye is adsorbed onto the semiconductor particles, the surface of the semiconductor particles may be treated with amines. Preferable examples of the amines include pyridines (such as 4-tert-butylpyridine and polyvinylpyridine) and the like. When the amines are in the form of a liquid, they may be used as is or may be used by being dissolved in an organic solvent.

In the photoelectric conversion element (such as the photoelectric conversion element 10) and the dye-sensitized solar cell (such as a dye-sensitized solar cell 20) of the present invention, at least the aforementioned metal complex dye of the present invention is used.

In the present invention, the metal complex dye used in the present invention may be concurrently used with other dyes.

Examples of the concurrently used dyes include the Ru complex dyes descried in JP1995-500630A (JP-H07-500630A) (particularly, the dyes synthesized in Examples 1 to 19 described in the 5^{th} line of left lower column on page 5 to the 7^{th} line of right upper column on page 7), the Ru complex dyes described in JP2002-512729A (particularly, the dyes synthesized in Examples 1 to 16 described in the 3^{rd} line from the bottom of page 20 to the 23^{rd} line on page 29), the Ru complex dyes described in JP2001-59062A (particularly, the dyes described in paragraphs [0087] to [0104]), the Ru complex dyes described in JP2001-6760A (particularly, the dyes described in paragraphs [0093] to [0102]), the Ru complex dyes described in JP2001-253894A (particularly, the dyes described in paragraphs [0009] and [0010]), the Ru complex dyes described in JP2003-212851A (particularly, the dyes described in paragraph [0005]), the Ru complex dyes described in WO2007/91525A (particularly, the dyes described in paragraphs [0067]), the Ru complex dyes described in JP2001-291534A (particularly, the dyes described in paragraphs [0120] to [0144]), the Ru complex dyes described in JP2012-012570A (particularly, the dyes described in paragraphs [0095] to [0103]), the Ru complex dyes described in JP2013-084594A (particularly, the dyes described in paragraphs [0072] to [0081] and the like), the squarylium cyanine dyes described in JP1999-214730A (JP-H11-214730A) (particularly, the dyes described in paragraphs [0036] to [0047]), the squarylium cyanine dyes described in JP2012-144688A (particularly, the dyes described in paragraphs [0039] to [0046] and paragraphs [0054] to [0060]), the squarylium cyanine dyes described in JP2012-84503A (particularly, the dyes described in paragraphs [0066] to [0076] and the like), organic dyes described in JP2004-063274A (particularly, the dyes described in paragraphs [0017] to [0021]), the organic dyes described in JP2005-123033A(particularly, the dyes described in paragraphs [0021] to [0028]), the organic dyes described in JP2007-287694A (particularly, the dyes described in paragraphs [0091] to [0096]), the organic dyes described in JP2008-71648A (particularly, the dyes described in paragraphs [0030] to [0034]), the organic dyes described in WO2007/119525A (particularly, the dyes described in paragraph [0024]), the porphyrin dyes described in Angew. Chem. Int. Ed., 49, 1 to 5 (2010) and the like, and the phthalocyanine dyes described in Angew. Chem. Int. Ed., 46, 8358 (2007).

Preferable examples of the concurrently used dyes include Ru complex dyes, squarylium cyanine dyes, and organic dyes.

When the metal complex dye used in the present invention is concurrently used with other dyes, a mass ratio of the metal complex dye used in the present invention/other dyes is preferably 95/5 to 10/90, more preferably 95/5 to 50/50, even more preferably 95/5 to 60/40, particularly preferably 95/5 to 65/35, and most preferably 95/5 to 70/30.

### -Charge transfer layer-

The charge transfer layer used in the photoelectric conversion element of the present invention is a layer that functions to supply electrons to the oxidized dye and is disposed between the light-receiving electrode and the counter electrode. The charge transfer layer contains an electrolyte. Examples of the electrolytes include a liquid electrolyte obtained by dissolving redox pairs in an organic solvent, so-called a gel electrolyte obtained by impregnating a polymer matrix with a solution obtained by dissolving redox pairs in an organic solvent, molten salts containing redox pairs, and the like. In order to improve the photoelectric conversion efficiency, it is preferable to use a liquid electrolyte. As the organic solvent of the liquid electrolyte, nitrile compounds, ether compounds, ester compounds, and the like are used. Among these, nitrile compounds are preferable, and acetonitrile and methoxypropionitrile are particularly preferable.

Examples of the redox pairs include a combination of iodine and an iodide (preferably an iodide salt or iodized ionic liquid including lithium iodide, tetrabutylammonium iodide, tetrapropylammonium iodide, and methyl propylimidazolium iodide), a combination of alkylviologen (such as methylviologen chloride, hexylviologen bromide, or benzylviologen tetrafluoroborate) and a reduced product thereof, a combination of polyhydroxybenzenes (such as hydroquinone and naphthohydroquinone) and a oxidized product thereof, a combination of a divalent iron complex and a trivalent iron complex (such as a combination of potassium ferricyanide and potassium ferrocyanide), a combination of a divalent cobalt complex and a trivalent cobalt complex, and the like. Among these, a combination of iodine and an iodide and a combination of a divalent cobalt complex and a trivalent cobalt complex are preferable.

The cobalt complex is particularly preferably a complex represented by the following Formula (CC).

Co(LL)ma(X)mb·CI Formula (CC)

In Formula (CC), LL represents a bidentate or tridentate ligand; X represents a monodentate ligand; ma represents an integer of 0 to 3; mb represents an integer of 0 to 6; and CI represents a counter ion used when a counter ion is required for neutralizing a charge.

Examples of CI include CI in Formula (I).

LL is preferably a ligand represented by the following Formula (LC).

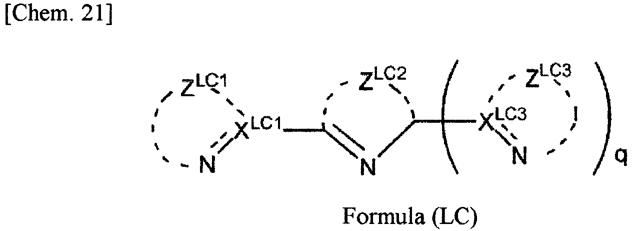

In Formula (LC), each of X^{LC1} and X^{LC3} independently represents a carbon atom or a nitrogen atom. Herein, when X^{LC1} is a carbon atom, the bond between X^{LC1} and a N atom is a double bond (X^{LC1}=N). When X^{LC3} is a carbon atom, a bond between X^{LC3} and a N atom represents a double bond (X^{LC3}=N). When X^{LC1} is a nitrogen atom, the bond between X^{LC1} and a N atom is a single bond (X^{LC1}-N). When X^{LC3} is a nitrogen atom, the bond between X^{LC3} and a N atom is a single bond (X^{LC3}-N).

Each of Z^{LC1}, Z^{LC2}, and Z^{LC3} independently represents a non-metallic atomic group necessary for forming a 5- or 6-membered ring. Z^{LC1}, Z^{LC2}, and Z^{LC3} may have a substituent and may form a closed ring via the substituent against a ring adjacent thereto. q represents 0 or 1. Examples of the substituent include the substituents T which will be described later. When q is 0, a hydrogen atom or a substituent other than a heterocyclic group formed by Z^{LC3} binds to a carbon atom in a position in which X^{LC3} binds to the 5- or 6-membered ring formed by Z^{LC2},

X is preferably a halogen ion.

The ligand represented by Formula (LC) is more preferably a ligand represented by the following Formulae (LC-1) to (LC-4).

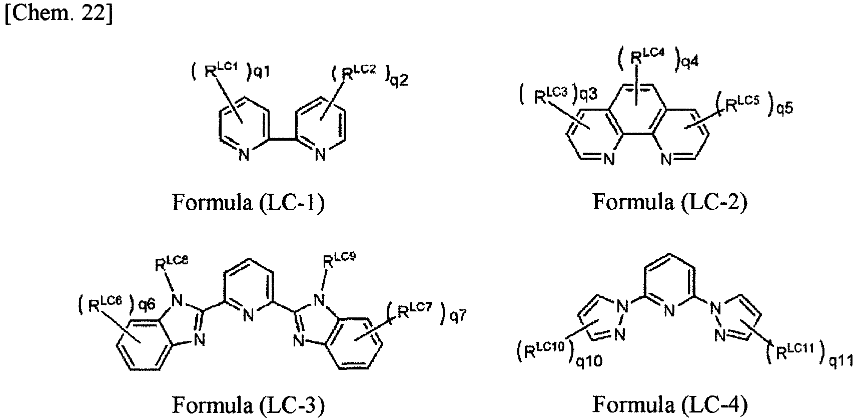

Each of R^{LC1} to R^{LC11} independently represents a substituent. Each of q1, q2, q6, and q7 independently represents an integer of 0 to 4. Each of q3, q5, q10, and q11 independently represents an integer of 0 to 3. q4 represents an integer of 0 to 2.

Specific examples of the substituents represented by R^{LC1} to R^{LC11} in Formulae (LC-1) to (LC-4) include an aliphatic group, an aromatic group, a heterocyclic group, and the like. Specific examples of the substituents include an alkyl group, an alkoxy group, an alkylthio group, an aryl group, an aryloxy group, an arylthio group, a heterocyclic group, and the like. Preferable examples thereof include an alkyl group (such as methyl, ethyl, n-butyl, n-hexyl, isobutyl, sec-butyl, t-butyl, n-dodecyl, cyclohexyl, or benzyl), an aryl group (such as phenyl, tolyl, or naphthyl), an alkoxy group (such as methoxy, ethoxy, isopropoxy, or butoxy), an alkylthio group (such as methylthio, n-butylthio, n-hexylthio, or 2-ethylhexylthio), an aryloxy group (such as phenoxy or naphtoxy), an arylthio group (such as phenylthio or naphthylthio) and a heterocyclic group (such as 2-thienyl or 2-furyl).

Specific examples of the cobalt complex having the ligand represented by Formula (LC) include the following complexes.

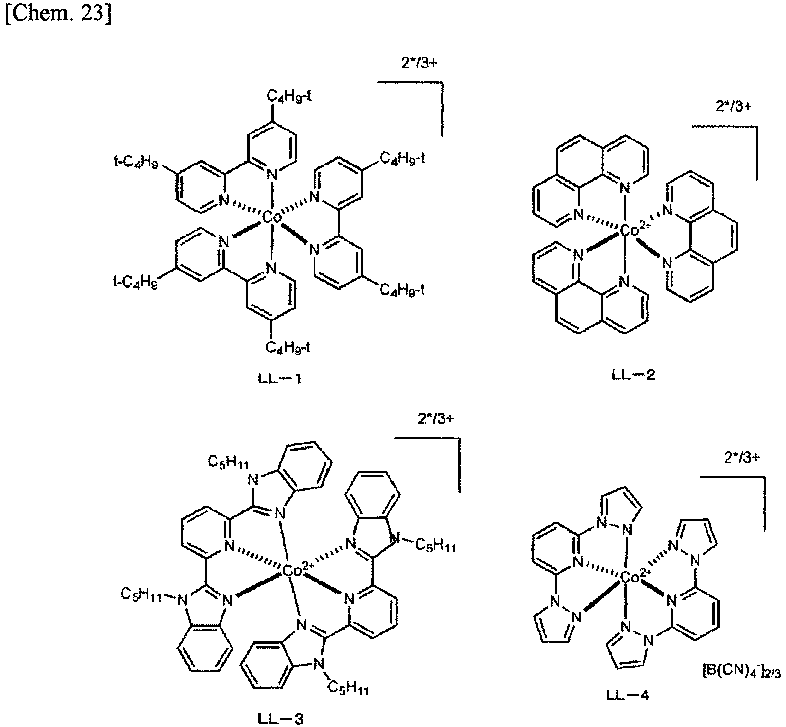

When a combination of iodine and an iodide is used as an electrolyte, it is preferable to concurrently use an iodine salt of a nitrogen-containing aromatic cation of a 5- or 6-membered ring.

As the organic solvent dissolving the redox pairs, nonprotonic polar solvents (such as acetonitrile, propylene carbonate, ethylene carbonate, dimethyl formamide, dimethyl sulfoxide, sulfolane, 1,3-dimethyl imidazolinone, and 3-methyl oxazolidionone) are preferable. Examples of the polymer used as the matrix of a gel electrolyte include polyacrylonitrile, polyvinylidene fluoride, and the like. Examples of the molten salt include those obtained by mixing polyethylene oxide with lithium iodide and at least one kind of another lithium salt (such as lithium acetate or lithium perchlorate) such that the resultant exhibit fluidity at room temperature. In this case, the amount of the polymer added is 1% by mass to 50% by mass. Furthermore, the electrolytic solution may contain γ-butyrolactone, and in this case, the iodide ion is more efficiently diffused, hence the conversion efficiency is improved.

As additives, an aminopyridine-based compound, a benzimidazole-based compound, an aminotriazole-based compound, an aminothiazole-based compound, an imidazole-based compound, an aminotriazine-based compound, a urea derivative, an amide compound, a pyrimidine-based compound, and a heterocyclic not containing nitrogen can be added to the electrolyte, in addition to the aforementioned 4-tert-butylpyridine,

Moreover, in order to improve the photoelectric conversion efficiency, a method of controlling water content in the electrolyte may be adopted. Preferable examples of the method of controlling water content include a method of controlling concentration and a method of adding a dehydrating agent to the electrolyte. In order to reduce toxicity of urea, a clathrate compound of urea and cyclodextrin may be used, or a method of consistently supplying water may be used. In addition, cyclic amidine may be used, or an antioxidant, a hydrolysis inhibitor, a stabilizing agent, or zinc iodide may be added.

The molten salts may be used as the electrolyte, and examples of preferable molten salts include an ionic liquid containing imidazolium or a triazolium-type cation, an oxazolium-based molten salt, a pyridinium-based molten salt, a guanidium-based molten salt, and a combination of these. These cationic molten salts may be combined with a specific anion. Furthermore, additives may be added to these molten salts, and the molten salts may have a liquid crystalline substituent. Moreover, quaternary ammonium salt-based molten salts may be used.

Examples of molten salts other than the above include those obtained by missing polyethylene oxide to lithium iodide and at least one kind of another lithium salt (such as lithium acetate or lithium perchlorate) such that the resultant exhibits fluidity at room temperature.

A gellant may be added to the electrolytic solution composed of the electrolyte and a solvent so as to cause gelation and make the electrolyte into a quasi-solid. Examples of the gellant include an organic compound having a molecular weight of equal to or less than 1,000, a Si-containing compound having a molecular weight within a range of 500 to 5,000, an organic salt formed of specific acidic compound and basic compound, a sorbitol derivative, and polyvinylpyridine.

Furthermore, a method of trapping a matrix polymer, a crosslinked polymer compound or monomer, a crosslinking agent, an electrolyte, and a solvent in a polymer may be used.

Preferable examples of the matrix polymer include polymers having a nitrogen-containing heterocyclic ring in a repeating unit of a main chain or a side chain, crosslinked polymers obtained by reacting the aforementioned polymers with an electrophilic compound, polymers having a triazine structure, polymers having a uride structure, polymers containing a liquid crystalline compound, polymers having an ether bond, polyvinylidene fluoride-based polymers, polymers based on methacrylate or acrylate, thermosetting resins, crosslinked polysiloxane, polyvinyl alcohol (PVA), clathrate compounds of polyalkylene glycol, dextrin, and the like, polymers to which a oxygen-containing polymer or a sulfur-containing polymer has been added, natural polymers, and the like. To these polymers, an alkali-swellable polymer, a polymer having a compound that can form a charge carrier complex composed of a cationic moiety and iodine in a single polymer, and the like may be added.

As the matrix polymer, polymers including a crosslinked polymer, which is obtained by reacting isocyanate having two or more functional groups with a functional group such as a hydroxyl group, an amino group, or a carboxyl group, may be used. Furthermore, a crosslinked polymer composed of a hydrosilyl group and a compound having a double bond may be used. In addition, a crosslinking method in which polysulfonic acid, polycarboxylic acid, or the like is reacted with a metallic ion compound having two or more functional groups may be used.

Examples of solvents that can be preferably used in combination with the aforementioned quasi-solidified electrolyte include a specific phosphoric acid ester, a mixed solvent containing ethylene carbonate, a solvent having a specific dielectric constant, and the like. Moreover, a method of keeping a solution of liquid electrolyte in a solid electrolyte membrane or in small pores, and preferable examples of such a method include methods using a conductive polymer film, a fibrous solid, or a cloth-like solid such as a filter.

Instead of the liquid electrolyte and the quasi-solidified electrolyte described above, a solid charge transport layer such as a p-type semiconductor or a hole transport material, for example, CuI, CuNSC, or the like can be used. Furthermore, the electrolyte described in Nature, vol. 486, p.487 (2012) and the like may be used. As the solid charge transport layer, an organic hole transport material may be used. Preferable examples of the hole transport layer include conductive polymers such as polythiophene, polyaniline, polypyrrole, and polysilane; spiro compounds in which two rings share a central element such as C or Si that forms a tetrahedral structure, aromatic amine derivatives such as triaryl amine, triphenylene derivatives, nitrogen-containing heterocyclic derivatives, and liquid crystalline cyano derivatives.

The redox pairs become electron carriers. Therefore, the total concentration thereof is preferably equal to or greater than 0.01 mol/L, more preferably equal to or greater than 0.1 mol/L, and particularly preferably equal to or greater than 0.3 mol/L. The upper limit of the total concentration of the redox pairs is not particularly limited, but is generally about 5 mol/L.

### -Coadsorbent-

In the photoelectric conversion element of the present invention, a coadsorbent is preferably used together with the metal complex dye used in the present invention or the dye that is concurrently used if necessary. As the coadsorbent, coadsorbents having one or more acidic groups (preferably a carboxyl group or a group of a salt thereof) are preferable, and examples thereof include fatty acids and compounds having a steroid skeleton. The fatty acid may be saturated fatty acids or unsaturated fatty acids, and examples thereof include butanoic acid, hexanoic acid, octanoic acid, decanoic acid, hexadecanoic acid, dodecanoic acid, palmitic acid, stearic acid, oleic acid, linoleic acid, linolenic acid, and the like.

Examples of the compounds having a steroid skeleton include cholic acid, glycocholic acid, chenodeoxycholic acid, hyocholic acid, deoxycholic acid, lithocholic acid, ursodeoxycholic acid, and the like. Among these, cholic acid, deoxycholic acid, and chenodeoxycholic acid are preferable, and chenodeoxycholic acid is more preferable.

As the coadsorbent, a compound represented by the following Formula (CA) is preferable.

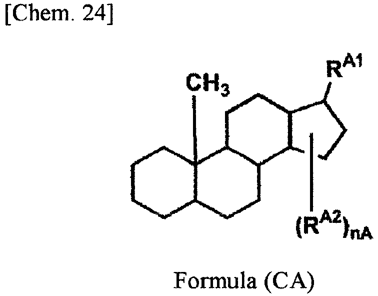

In the formula, R^{A1} represents a substituent having an acidic group; R^{A2} represents a substituent; and nA represents an integer of equal to or greater than 0.

R^{A1} represents a substituent having an acidic group. The acidic group of the substituent having an acidic group is a substituent having a dissociable proton, and pKa thereof is equal to or less than 11. Examples of the acidic group include groups having acidity, such as a carboxy group, a phosphonyl group, a phosphoryl group, a sulfo group, and a boric acid group, and salts thereof. Among these, a carboxy group, a sulfo group, or salts thereof are preferable, and carboxy group or salts thereof are more preferable.

When the acidic group is a salt, the counter ion at the time when the salt is formed is not particularly limited. Examples of the counter ion include the positive ions exemplified for the counter ion CI in Formula (I).

The substituent having an acidic group is a group substituted with an acidic group, and examples thereof include an alkyl group substituted with an acidic group, an alkenyl group substituted with an acidic group, an aryl group substituted with an acidic group, and a heterocyclic group substituted with an acidic group. Among these, an alkyl group substituted with an acidic group and an alkenyl group substituted with an acidic group are preferable, and an alkyl group substituted with an acidic group is particularly preferable.

In the alkyl group substituted with an acidic group, the number of carbon atoms of only the alkyl group excluding the acidic group is preferably 1 to 10, and more preferably 2 to 6.

Among the above, R^{A1} preferably represents an alkyl group substituted with a carboxyl group, a sulfo group, or a salt thereof, and more preferably represents -CH(CH₃)CH₂CH₂CO₂H and -CH(CH₃)CH₂CH₂CONHCH₂CH₂SO₃H.

Examples of R^{A2} include the substituents T which will be described later. Among the substituents T, an alkyl group, a hydroxy group, an acyloxy group, and an alkylaminocarbonyloxy group, an arylaminocarbonyloxy group are preferable, and an alkyl group, a hydroxy group, and an acyloxy group are more preferable.

nA is preferably 2 to 4.

Examples of these specific compounds include the compounds exemplified as the compounds having a steroid skeleton.

The coadsorbent used in the present invention is adsorbed onto the semiconductor particles, and in this way, the coadsorbent exerts an effect of inhibiting inefficient intermixing of dyes and an effect of preventing electrons from moving back to the redox system in the electrolyte from the surface of the semiconductor particles. The amount of the coadsorbent used is not particularly limited. However, from the viewpoint of making the coadsorbent excellently exert the aforementioned effects, the amount thereof is preferably 1 mol to 200 mol, more preferably 10 mol to 150 mol, and particularly preferably 20 mol to 50 mol, with respect to 1 mol of the dye.

### <Substituents T>

In the present specification, a "compound (including a complex and dye)" means not only the compound itself but also a salt, a complex, and an ion thereof. Furthermore, within a range that brings about intended effects, it also means a derivative obtained by changing a predetermined portion of the compound. In addition, in the present specification, when there is no description regarding whether or not a substituent is substituted or unsubstituted, it means that the substituent may have any substituent (the same will applied to a linking group and a ligand). Similarly, when there is not description regarding whether or not a compound is substituted or unsubstituted, the compound may have any substituent. Examples of preferable substituents include the following substituents T.

Moreover, in the present specification, when a group is simply described as a "substituent", the substituents T can be referred to for the "substituent". In addition, when a group is simply described as, for example, an "alkyl group", a preferable range and specific examples of groups corresponding to the substituents T are applied to the group.

Examples of the substituents T include the following substituents.

An alkyl group (preferably having 1 to 20 carbon atoms, for example, methyl, ethyl, isopropyl, t-butyl, pentyl, heptyl, 1-ethylpentyl, benzyl, 2-ethoxyethyl, 1-carboxymethyl, or trifluoromethyl), an alkenyl group (preferably having 2 to 20 carbon atoms, for example, vinyl, allyl, or oleyl), an alkynyl group (preferably having 2 to 20 carbon atoms, for example, ethynyl, butadienyl, or phenylethynyl), a cycloalkyl group (preferably having 3 to 20 carbon atoms, for example, cyclopropyl, cyclopentyl, cyclohexyl, or 4-methylcyclohexyl), a cycloalkenyl group (preferably having 5 to 20 carbon atoms, for example, cyclopentenyl or cyclohexenyl), an aryl group (preferably having 6 to 26 carbon atoms, for example, phenyl, 1-naphthyl, 4-methoxyphenyl, 2-chlorophenyl, or 3-methylphenyl), a heterocyclic group (preferably having 2 to 20 carbon atoms; the heterocyclic group is more preferably a heterocyclic group in the form of a 5- or 6-membered ring having at least one oxygen atom, sulfur atom, or nitrogen atom in ring-constituting atoms, for example, 2-pyridyl, 4-pyridyl, 2-imidazolyl, 2-benzimidazolyl, 2-thiazolyl, or 2-oxazolyl), an alkoxy group (preferably having 1 to 20 carbon atoms, for example, methoxy, ethoxy, isopropyloxy, or benzyloxy), an alkenyloxy group (preferably having 2 to 20 carbon atoms, for example, vinyloxy or allyloxy), an alkynyloxy group (preferably having 2 to 20 carbon atoms, for example, 2-propynyloxy or 4-butynyloxy), a cycloalkyloxy group (preferably having 3 to 20 carbon atoms, for example, cyclopropyloxy, cyclopentyloxy, cyclohexyloxy, or 4-methylcyclohexyloxy), an aryloxy group (preferably having 6 to 26 carbon atoms, for example, phenoxy, 1-naphthyloxy, 3-methylphenoxy, or 4-methoxyphenoxy), a heterocyclic oxy group (for example, imidazolyloxy, benzimidazolyloxy, thiazolyloxy, benzothiazolyloxy, triazinyloxy, or purinyloxy),

an alkoxycarbonyl group (preferably having 2 to 20 carbon atoms, for example, ethoxycarbonyl or 2-ethylhexyloxycarbonyl), a cycloalkoxycarbonyl group (preferably having 4 to 20 carbon atoms, for example, cyclopropyloxycarbonyl, cyclopentyloxycarbonyl, or cyclohexyloxycarbonyl), an aryloxycarbonyl group (preferably having 6 to 20 carbon atoms, for example, phenyloxycarbonyl or naphthyloxycarbonyl), an amino group (preferably having 0 to 20 carbon atoms, including an alkylamino group, an alkenylamino group, an alkynylamino group, a cycloalkylamino group, a cycloalkenylamino group, an arylamino group, and a heterocyclic amino group, for example, amino, N,N-dimethylamino, N,N-diethylamino, N-ethylamino, N-allylamino, N-(2-propynyl)amino, N-cyclohexylamino, N-cyclohexenylamino, aniline, pyridylamino, imidazolylamino, benzimidazolylamino, thiazolylamino, benzothiazolylamino, or triazinylamino), a sulfamoyl group (preferably having 0 to 20 carbon atoms; the sulfamoyl group is preferably a sulfamoyl group of alkyl, cycloalkyl, or aryl, for example, N,N-dimethylsulfamoyl, N-cyclohexylsulfamoyl, or N-phenylsulfamoyl), an acyl group (preferably having 1 to 20 carbon atoms, for example, acetyl, cyclohexylcarbonyl, or benzoyl), an acyloxy group (preferably having 1 to 20 carbon atoms, for example, acetyloxy, cyclohexylcarbonyloxy, or benzoyloxy), a carbamoyl group (preferably having 1 to 20 carbon atoms; the carbamoyl group is preferably a carbamoyl group of alkyl, cycloalkyl, or aryl, for example, N,N-dimethylcarbamoyl, N-cyclohexylcarbamoyl, or N-phenylcarbamoyl),

an acylamino group (preferably an acylamino group having 1 to 20 carbon atoms, for example, acetylamino, cyclohexylcarbonylamino, or benzoylamino), a sulfonamide group (preferably having 0 to 20 carbon atoms; the sulfonamide group is preferably a sulfonamide group of alkyl, cycloalkyl, or aryl, for example, methanesulfonamide, benzenesulfonamide, N-methylmethanesulfonamide, N-cyclohexylsulfonamide, or N-ethylbenzenesulfonamide), an alkylthio group (preferably having 1 to 20 carbon atoms, for example, methylthio, ethylthio, isopropylthio, or benzylthio), a cycloalkylthio group (preferably having 3 to 20 carbon atoms, for example, cyclopropylthio, cyclopentylthio, cyclohexylthio, or 4-methylcyclohexylthio), an arylthio group (preferably having 6 to 26 carbon atoms, for example, phenylthio, 1-naphthylthio, 3-methylphenylthio, or 4-methoxyphenylthio), an alkylsulfonyl group, a cycloalkylsulfonyl group, or an arylsulfonyl group (preferably having 1 to 20 carbon atoms, for example, methylsulfonyl, ethylsulfonyl, cyclohexylsulfonyl, or benzenesulfonyl),

a silyl group (preferably having 1 to 20 carbon atoms; the silyl group is preferably a silyl group substituted with alkyl, aryl, alkoxy, and aryloxy, for example, triethylsilyl, triphenylsilyl, diethylbenzylsilyl, or dimethylphenylsilyl), a silyloxy group (preferably having 1 to 20 carbon atoms; the silyloxy group is preferably a silyloxy group substituted with alkyl, aryl, alkoxy, and aryloxy, for example, triethylsilyloxy, triphenylsilyloxy, diethylbenzylsilyloxy, or dimethylphenylsilyloxy), a hydroxyl group, a cyano group, a nitro group, a halogen atom (such as a fluorine atom, a chlorine atom, a bromine atom, or an iodine atom), a carboxyl group, a sulfo group, a phosphonyl group, a phosphoryl group, and a boric acid group.

When a compound, a substituent, and the like contain an alkyl group, an alkenyl group, and the like, these may be linear or branched or may be substituted or unsubstituted. Furthermore, when a compound, a substituent, and the like contain an aryl group, a heterocyclic group, and the like, these may be monocyclic or polycyclic or may be substituted or unsubstituted.

### <Counter electrode>

It is preferable for the counter electrode to functions as a cathode of the dye-sensitized solar cell (photoelectrochemical cell). Although the counter electrode generally has the same definition as the aforementioned conductive substrate, the supporter is not essentially required when the solar cell is constituted to sufficiently maintain the strength. It is preferable for the counter electrode to have a structure exerting a high current-collecting effect. In order to allow light to reach the photosensitive layer, at least one of the conductive substrate and the counter electrode should be substantially transparent. In the dye-sensitized solar cell of the present invention, it is preferable to make the conductive substrate transparent and to cause sunlight to enter from the side of the supporter. In this case, it is more preferable for the counter electrode to have a property of reflecting the light. As the counter electrode of the dye-sensitized solar cell, glass or plastic onto which a metal or a conductive oxide has been vapor-deposited is preferable, and glass onto which platinum has been vapor-deposited is particularly preferable. In the dye-sensitized solar cell, in order to prevent evaporation of constituents of the cell, it is preferable to seal the surface of the cell side by using a polymer, an adhesive, or the like.

The present invention can be applied to the photoelectric conversion elements and the dye-sensitized solar cells described in JP4260494B, JP2004-146425A, JP2000-340269A, JP2002-289274A, JP2004-152613A, and JP1997-27352A (JP-H09-27352A). Furthermore, the present invention can be applied to the photoelectric conversion elements and the dye-sensitized solar cells described in JP2004-152613A, JP2000-90989A, JP2003-217688A, JP2002-367686A, JP2003-323818A, JP2001-43907A, JP2000-340269A, JP2005-85500A, JP2004-273272A, JP2000-323190A, JP2000-228234A, JP2001-266963A, JP2001-185244A, JP2001-525108A, JP2001-203377A, JP2000-100483A, JP2001-210390A, JP2002-280587A, JP2001-273937A, JP2000-285977A, JP2001-320068A, and the like.

«Dye solution and manufacturing method of dye-adsorbed electrode and dye-sensitized solar cell using the dye solution»

In the present invention, it is preferable to manufacture a dye-adsorbed electrode by using a dye solution containing the metal complex dye used in the present invention.

In such a dye solution, the metal complex dye used in the present invention is dissolved in an organic solvent, and if necessary, the dye solution may contain a coadsorbent or other components.

Examples of the solvent used include the solvents described in JP2001-291534A, but the solvent is not particularly limited. In the present invention, an organic solvent is preferable, and alcohols, amides, nitriles, hydrocarbons, and a mixed solvent consisting of two or more kinds of these are more preferable. The mixed solvent is preferably a mixed solvent obtained by mixing alcohols with a solvent selected from among amides, nitriles, or hydrocarbons, more preferably a mixed solvent consisting of alcohols and amides or consisting of alcohols and hydrocarbons, and particularly preferably a mixed solvent consisting of alcohols and amides. Specifically, methanol, ethanol, propanol, butanol, dimethylformamide, and dimethylacetamide are preferable.

The dye solution preferably contains a coadsorbent. As the coadsorbent, the aforementioned coadsorbetns are preferable, and among these, the compound represented by Formula (CA) is preferable.

Herein, it is preferable to adjust the concentration of the metal complex dye or the coadsorbent in the dye solution used in the present invention, such that the solution can be used as is for manufacturing the photoelectric conversion element or the dye-sensitized solar cell. In the present invention, the dye solution preferably contains the metal complex dye used in the present invention, in an amount of 0.001% by mass to 0.1% by mass.

It is particularly preferable for adjust the water content in the dye solution. Therefore, in the present invention, it is preferable to adjust the water content to be 0% by mass to 0.1% by mass.

Likewise, in order to make the effects of the present invention excellently exerted, it is preferable to adjust the water content of the electrolyte in the photoelectric conversion element or the dye-sensitized solar cell. Therefore, it is preferable to adjust the water content of the electrolyte to be 0% by mass to 0.1% by mass. It is particularly preferable to use the dye solution to prepare the electrolytic solution.

In the present invention, a dye-adsorbed electrode is preferable which is a semiconductor electrode for a dye-sensitized solar cell obtained by causing the metal complex dye to be supported on the surface of the semiconductor particles contained in a semiconductor electrode by using the aforementioned dye solution.

That is, the dye-adsorbed electrode for a dye-sensitized solar cell is preferably obtained in the form of a photosensitive layer that is prepared by coating a conductive substrate containing semiconductor particles with a composition obtained from the dye solution and then curing the composition.

In the present invention, the dye-sensitized solar cell is preferably manufactured by using the dye-adsorbed electrode for a dye-sensitized solar cell, preparing an electrolyte and a counter electrode, and assembling these together.

### Examples

Hereinafter, the present invention will be more specifically described based on examples, but the present invention is not limited thereto.

### (Example 1)

### <Synthesis of metal complex dye>

Hereinafter, a synthesis method of the metal complex dye used in the present invention will be specifically described. However, the starting material, the dye intermediate, and the synthesis route are not limited to the synthesis method.

### Example 1 (synthesis of metal complex dye)

Ligands of a metal complex dye were synthesized according to a method of the following scheme, thereby synthesizing a metal complex dye (TL13-1).

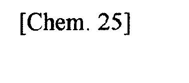

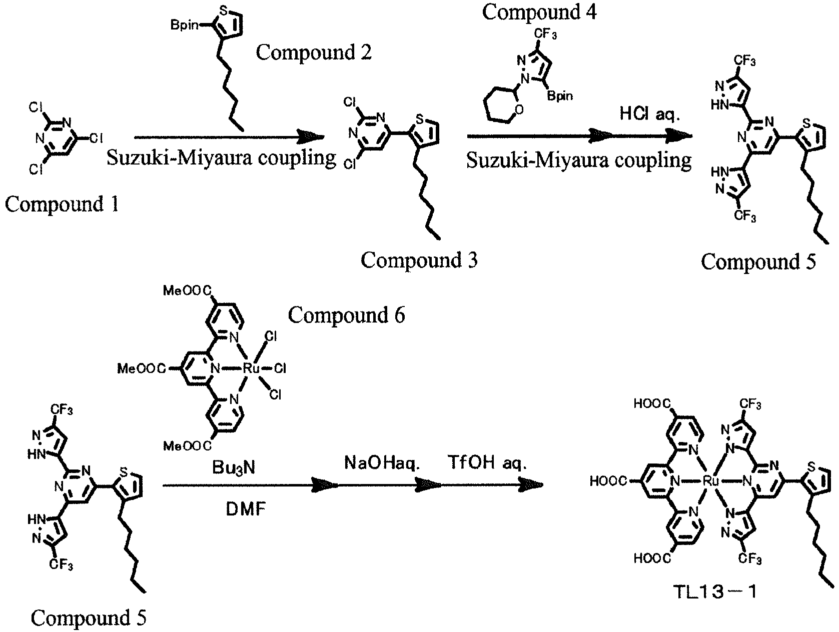

9 g of a compound 1, 4.81 g of a compound 2, 9.04 g of potassium carbonate, 30 ml of distilled water, and 30 ml of toluene were put into a three-neck flask, and then deaeration and nitrogen purging were performed. Thereafter, 0.945 g of tetrakis(triphenylphosphinepalladium) was added thereto, and the resultant was heated under reflux for 9 hours in nitrogen. The obtained reaction liquid was cooled to room temperature and purified by silica gel column chromatography using hexane/ethyl acetate as an eluent, thereby obtaining 3.4 g of a compound 3.

1 g of the compound 3, 2.7 g of a compound 4, 2.7 g of tripotassium phosphate, 0.3 g of S-Phos(2-Dicyclohexylphosphino-2',6'-dimethoxybiphenyl), 10 ml of distilled water, and 10 ml of tetrahydrofuran (THF) were put into a three-neck flask, and then deaeration and nitrogen purging were performed. Thereafter, 71 mg of palladium acetate was added thereto, and the resultant was heated under reflux for 9 hours in nitrogen. The obtained reaction liquid was cooled to room temperature, purified by silica gel column chromatography using hexane/ethyl acetate as an eluent, and treated with hydrochloric acid so as to cause recrystallization, thereby obtaining 0.3 g of a compound 5. Subsequently, 0.3 g of the compound 5, 0.35 g of a compound 6, 5 ml of N,N-dimethylformamide, and 0.63 g of tributylamine were put into a three-neck flask, and the resultant was heated under reflux for 8 hours at 100°C. Then the obtained reaction liquid was purified by silica gel column chromatography using methylene chloride/ethyl acetate as an eluent. Thereafter, the purified resultant was hydrolyzed by using sodium hydroxide in DMF, and then an aqueous trifluoromethanesulfonic acid solution and distilled water were added thereto. The generated precipitate was filtered, washed with water, and dried, thereby obtaining 60 mg of the metal complex dye (TL13-1). The compound was identified by ESI-MS.
Mass spectrometry data (ESI-MS): [M-H]⁺ = 981

Metal complex dyes used in examples were synthesized in the same manner as above.

### Example 2 (preparation of dye-sensitized solar cell)

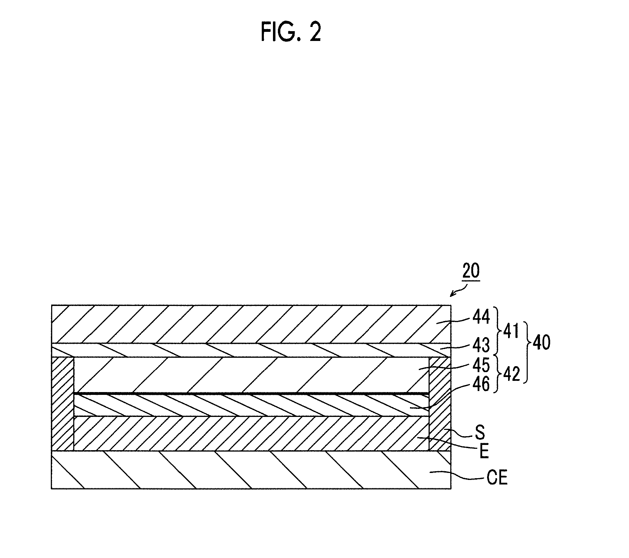

According to the following procedure, a photoelectrode was prepared which had the same constitution as the photoelectrode 12 shown in Fig. 5 described in JP2002-289274A. Furthermore, by using the photoelectrode, a 10 mm × 10 mm dye-sensitized solar cell 1 was prepared which had the same constitution as the dye-sensitized solar cell 20 except for the photoelectrode shown in Fig. 3 of the same document. The specific constitution thereof is shown in Fig. 2. In Fig. 2, "41" indicates a transparent electrode, "42" indicates a semiconductor electrode, "43" indicates a transparent conductive film, "44" indicates a substrate, "45" indicates a semiconductor layer, "46" indicates a light-scattering layer, "40" indicates a photoelectrode, "20" indicates a dye-sensitized solar cell, "CE" indicates a counter electrode, "E" indicates an electrolyte, and "S" indicates a spacer.

### (Preparation of paste)

(Paste A) Spherical TiO₂ particles (anatase; mean particle size: 25 nm; hereinafter, referred to as "spherical TiO₂ particles A") were added to a nitric acid solution, and the solution was stirred, thereby preparing titania slurry. Then a cellulose-based binder was added as a thickener to the titania slurry, and the resultant was kneaded, thereby preparing a paste A.

(Paste 1) The spherical TiO₂ particles A and spherical TiO₂ particles (anatase; mean particle size: 200 nm; hereinafter, referred to as "spherical TiO₂ particles B) were added to a nitric acid solution, and the solution was stirred, thereby preparing titania slurry. Then a cellulose-based binder was added as a thickener to the titania slurry, and the resultant was kneaded, thereby preparing a paste 1 (mass of TiO₂ particles A:mass of TiO₂ particles B = 30:70).

(Paste 2) The paste A was mixed with rod-shaped TiO₂ particles (anatase; diameter; 100 nm; aspect ratio: 5; hereinafter, referred to as "rod-shaped TiO₂ particles C), thereby preparing a paste 2 (mass of rod-shaped TiO₂ particles:mass of paste A = 30:70).

### (Preparation of semiconductor electrode)

A fluorine-doped SnO₂ conductive film (film thickness: 500 nm) was formed on a glass substrate, thereby preparing a transparent electrode. Thereafter, the paste 1 was printed on the SnO₂ conductive film by screen printing and then dried. Then the resultant was calcined under the conditions of 450°C under an atmosphere. In addition, the screen printing and calcining were repeated by using the paste 2. In this way, a semiconductor electrode (area of light-receiving surface: 10 mm × 10 mm; layer thickness: 10 µm, thickness of the semiconductor layer: 6µm; thickness of the light-scattering layer: 4 µm; amount of the rod-shaped TiO₂ particles C contained in the light-scattering layer: 30% by mass) having the same constitution as the semiconductor electrode 42 shown in Fig. 2 was formed on the SnO₂ conductive film, and a photoelectrode not containing a dye was prepared.

### (Adsorption of dye)

Thereafter, a dye was adsorbed onto the semiconductor electrode (precursor of a dye-adsorbed electrode) in the following manner. First, a mixture containing anhydrous t-butanol, which was dehydrated over magnesium ethoxide, and dimethylformamide at a ratio of 1:1 (volume ratio) was used as a solvent, and the metal complex dyes listed in the following Table 1 were dissolved in the solvent such that the concentration became 3 × 10⁻⁴ mol/L. Furthermore, as a coadsorbent, an equimolar mixture of chenodeoxyglycholic acid and cholic acid was added to the solution, in an amount of 20 mol with respect to 1 mol of each of the metal complex dyes, thereby preparing dye solutions. As a result of measuring the water content in the dye solutions by Karl Fischer titration, it was confirmed that the amount of water was less than 0.01% by mass. Thereafter, the semiconductor electrode was dipped in each of the dye solutions for 10 hours at 40°C, pulled up, and then dried at 50°C. In this way, photoelectrodes 40 were completed in which the dye was adsorbed onto the semiconductor electrode in an amount of about 2 ×10⁻⁷ mol/cm².

### (Assembly of dye-sensitized solar cell)

Subsequently, as a counter electrode, a platinum electrode (thickness of thin Pt film: 100 nm) having the same size and shape as the aforementioned photoelectrode was prepared, and as an electrolyte, a urea-based redox acetonitrile solution containing 0.1 M of urea, 0.05 M of lithium iodide, and 0.25 M of 4-t-butylpyridine was prepared. Moreover, a spacer S (trade name: "Surlyn") manufactured by DuPont having a shape matching with the size of the semiconductor electrode was prepared. Thereafter, the photoelectrode 40 and the counter electrode CE were caused to face each other across the spacer S and subjected to thermocompression; the inside thereof was filled with the electrolyte; and the periphery and the electrolytic solution inlet of the prepared cell were sealed by using a resin XNR-5516 manufactured by Nagese ChemteX Corporation; and the cell was cured. In this way, dye-sensitized solar cells (specimen Nos. 101 to 110 and c11 to c16) were completed respectively. The performance of the dye-sensitized solar cells was evaluated as below.

### <Evaluation of heat deterioration (heat resistance)>

The prepared dye-sensitized solar cells were subjected to a heat resistance test by being put into a thermostatic bath at 40°C. The dye-sensitized solar cells having not yet been subjected to the heat resistance test and the dye-sensitized solar cells left for 12 hours after the heat resistance test were evaluated in terms of current. The decrease in a current value after the heat resistance test was divided by a current value before the heat resistance test, and the thus obtained value was taken as a rate of heat deterioration. Then the obtained rate of heat deterioration was divided by the rate of heat deterioration obtained by using the following comparative compound (1), and the heat deterioration was evaluated according to the following criteria.
A: The rate of heat deterioration is less than 0.9-fold.
B: The rate of heat deterioration is equal to or greater than 0.9-fold and less than 1-fold.
C: The rate of heat deterioration is equal to or greater than 1-fold.

The results are shown in the column of heat deterioration of the following Table 1.

### <Heat cycle test>

The prepared dye-sensitized solar cells were repeatedly cooled and heated by being alternately put into a freezer at -10°C and then into a thermostatic bath at 20°C every two hours. In this way, a heat cycle test was performed. The dye-sensitized solar cells having not yet been subjected to the heat cycle test and the dye-sensitized solar cell left for 24 hours after the heat cycle test were evaluated in terms of current. The decrease in a current value after the heat cycle test was divided by a current value before the heat cycle test, and the obtained value was taken as a rate of deterioration. Then the obtained rate of deterioration was divided by a rate of deterioration obtained by using the following comparative compound (1), and the heat cycle properties were evaluated according to the following criteria.
A: The rate of deterioration is less than 0.9-fold.
B: The rate of deterioration is equal to or greater than 0.9-fold and less than 1-fold.
C: The rate of deterioration is equal to or greater than 1-fold.

The results are shown in the column of heat cycle of the following Table 1.

These results are summarized in the following Table 1.

**[Table 1]**

| Specimen No. | Metal complex dye | Ligand LA Formula No. | Ligand LD Formula No. | Heat deterioration | Heat cycle | Note |
|---|---|---|---|---|---|---|
| 101 | TL13-1 | AL-1 | DL-1 | A | B | Present invention |
| 102 | TL13-25 | AL-1 | DL-1 | A | B | Present invention |
| 103 | TL13-32 | AL-1 | DL-1 | A | B | Present invention |
| 104 | TL13-35 | AL-1 | DL-1 | A | B | Present invention |
| 105 | TL14-12 | AL-1 | DL-2 | B | A | Present invention |
| 106 | TL14-19 | AL-1 | DL-2 | B | A | Present invention |
| 107 | TL15-2 | AL-1 | DL-4 | B | B | Present invention |
| 108 | TL23-32 | AL-2 | DL-1 | A | B | Present invention |
| 109 | TL24-12 | AL-2 | DL-2 | B | A | Present invention |
| 110 | TL25-2 | AL-2 | DL-4 | B | B | Present invention |
| c11 | Comparative compound (1) | AL-1 | - | C | C | Comparative example |
| c12 | Comparative compound (2) | AL-1 | - | C | C | Comparative example |
| c13 | Comparative compound (3) | AL-1 | - | C | C | Comparative example |
| c14 | Comparative compound (4) | AL-1 | - | C | C | Comparative example |
| c15 | Comparative compound (5) | AL-1 | - | C | C | Comparative example |
| c16 | Comparative compound (6) | AL-2 | - | C | C | Comparative example |

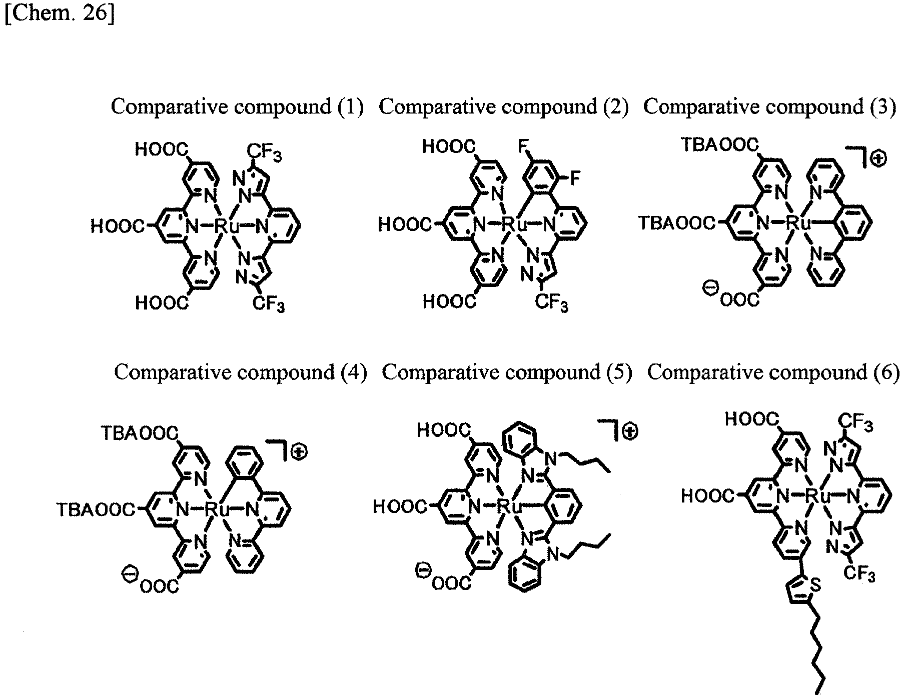

Herein, TBA represents tetrabutylammonium.

Furthermore, the comparative compounds used are as follows.
Comparative compound (1): Compound TF-1 (standard compound of each evaluation) described in US2012/0073660A
Comparative compound (2): Compound TF-6 described in US2012/0073660A
Comparative compound (3): Compound T4 described in JP2009-67976A
Comparative compound (4): Compound T5 described in JP2009-67976A
Comparative compound (5): Compound T7 described in JP2009-67976A
Comparative compound (6): Compound TF-11 described in Journal of the American Chemical Society, No. 134, Vol. 17, pp 7488-7496 (2012)

As is evident from the Table 1, the photoelectric conversion element and the dye-sensitized solar cell of the present invention exhibit excellent durability under various conditions.

## Claims

1. A photoelectric conversion element comprising:
a conductive substrate;
a photosensitive layer containing an electrolyte;
a charge transfer layer containing an electrolyte; and
a counter electrode,
wherein the photosensitive layer contains semiconductor particles loaded with a metal complex dye represented by the following Formula (I),
M(LD)(LA)·(CI) Formula (I),
in the formula, M represents a metal ion; LD represents a ligand represented by any of the following Formulae (DL-1) to (DL-4); LA represents a ligand represented by the following Formula (AL-1) or (AL-2); and CI represents a counter ion necessary for neutralizing a charge, 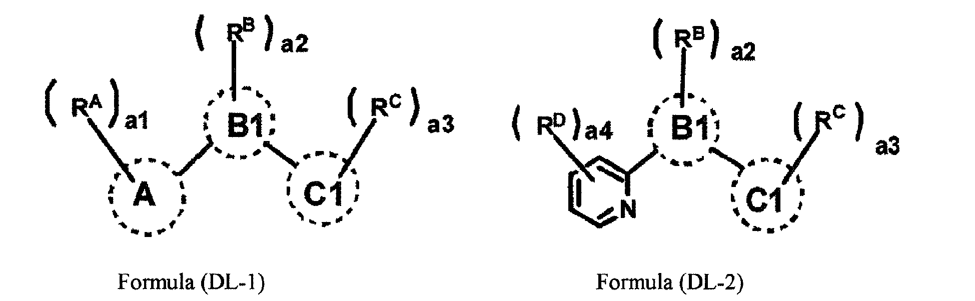
in the formulae, each of a ring A and a ring C1 independently represents any of a pyrazol ring that binds to the metal ion M through a nitrogen atom, a pyrrol ring, an imidazole ring that binds to the metal ion M through a nitrogen atom, an oxazole ring, a thiazole ring, an oxadiazole ring, a thiadiazole ring, an isoxazole ring, an isothiazole ring, a triazole ring, a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, a pyrazole ring that binds to the metal ion M through a carbon atom, and an imidazole ring that binds to the metal ion M through a carbon atom; a ring B 1 represents any of a pyrimidine ring, a triazine ring, an imidazole ring that binds to the metal ion M through a nitrogen atom, an imidazole ring that binds to the metal ion M through a carbon atom (carbene), an oxazole ring, a thiazole ring, an oxadiazole ring, a thiadiazole ring, a triazole ring, and a pyrazole ring; each of R^{A} to R^{D} independently represents a substituent; each of a1 to a3 independently represents an integer of equal to or greater than 0, and a4 represents an integer of 0 to 4; and when each of R^{A} to R^{D} is present in plural numbers, they may form a ring by binding to each other, 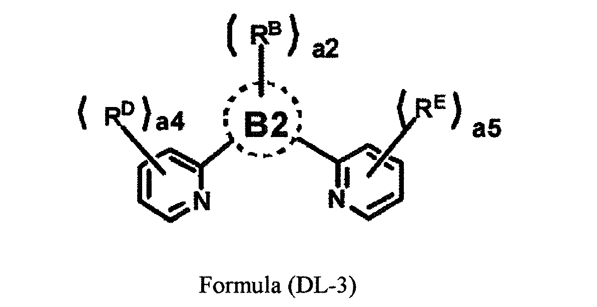
in the formula, a ring B2 represents any of a pyrimidine ring, a triazine ring, an imidazole ring that binds to the metal ion M through a nitrogen atom, an imidazole ring that binds to the metal ion M through a carbon atom (carbene), an oxazole ring, a thiazole ring, an oxadiazole ring, a thiadiazole ring, a triazole ring, a pyrazole ring, a pyrrole ring that binds to the metal ion M through a carbon atom, and a non-aromatic heterocyclic ring; each of R^{B}, R^{D}, and R^{E} independently represents a substituent; a2 represents an integer of equal to or greater than 0; each of a4 and a5 independently represents an integer of 0 to 4; and when each of R^{B}, R^{D}, and R^{E} is present in plural numbers, they may form a ring by binding to each other, 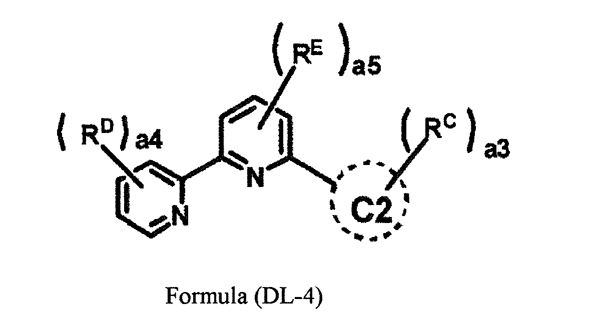
in the formula, a ring C2 represents any of a pyrimidine ring, a pyrazine ring, a pyridazine ring, a triazine ring, a pyridine ring that binds to the metal ion M through a carbon atom, a thiophene ring that binds to the metal ion M through a carbon atom, a furan ring that binds to the metal ion M through a carbon atom, an imidazole ring, an oxazole ring, a thiazole ring, an oxadiazole ring, a thiadiazole ring, an isoxazole ring, an isothiazole ring, a triazole ring, a pyrazole ring, and a pyrrole ring; each of R^{C}, R^{D}, and R^{E} independently represents a substituent; a3 represents an integer of equal to or greater than 0; each of a4 and a5 independently represents an integer of 0 to 4; and when each of R^{C}, R^{D}, and R^{E} is present in plural numbers, they may form a ring by binding to each other, 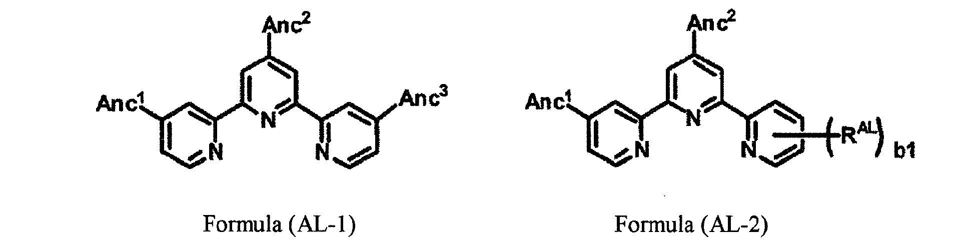
in the formulae, each of Anc¹ to Anc³ independently represents -CO₂H, -SO₃H, -PO₃H₂, or a group formed by dissociation of protons of these; R^{AL} represents a substituent; and b1 represents an integer of 0 to 4.

2. The photoelectric conversion element according to claim 1,
wherein M in Formula (I) is Fe²⁺, Ru²⁺, or Os²⁺.

3. The photoelectric conversion element according to claim 1 or 2,
wherein LD in Formula (I) is represented by Formula (DL-1) or (DL-2), each of the ring A and the ring C1 independently represents any of a pyrazole ring that binds to the metal ion M through a nitrogen atom, a pyrrole ring, a pyridine ring that binds to the metal ion M through a carbon atom, a thiophene ring that binds to the metal ion M through a carbon atom, a furan ring that binds to the metal ion M through a carbon atom, and a pyrazole ring that binds to the metal ion M through a carbon atom, and the ring B 1 is either a pyrimidine ring or a triazine ring.

4. The photoelectric conversion element according to claim 1 or 2,
wherein LD in Formula (I) is represented by Formula (DL-3), and the ring B2 is a triazole ring or a non-aromatic nitrogen-containing heterocyclic ring.

5. The photoelectric conversion element according to claim 1 or 2,
wherein LD in Formula (I) is represented by Formula (DL-4), and the ring C2 is any of a pyrrole ring, a pyridine ring that binds to the metal ion M through a carbon atom, a thiophene ring that binds to the metal ion M through a carbon atom, a furan ring that binds to the metal ion M through a carbon atom, and a pyrazole ring that binds to the metal ion M through a carbon atom.

6. The photoelectric conversion element according to any one of claims 1 to 5,
wherein LA in Formula (I) is represented by Formula (AL-1).

7. The photoelectric conversion element according to any one of claims 1 to 5,
wherein LA in Formula (I) is represented by Formula (AL-2).

8. The photoelectric conversion element according to any one of claims 1 to 7,
wherein the semiconductor particles are further loaded with a coadsorbent having one or more acidic groups.

9. The photoelectric conversion element according to claim 8,
wherein the coadsorbent is represented by the following Formula (CA), 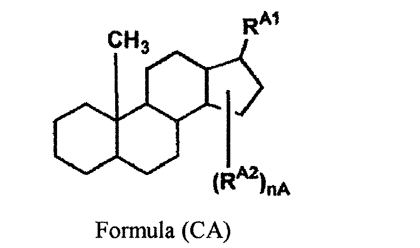 in the formula, R^{A1} represents a substituent having an acidic group; R^{A2} represents a substituent, and nA represents an integer of equal to or greater than 0.

10. A dye-sensitized solar cell comprising the photoelectric conversion element according to any one of claims 1 to 9.
